(19) **Europäisches Patentamt / European Patent Office / Office européen des brevets**

(11) **EP 3 467 880 A1**

(12) **EUROPEAN PATENT APPLICATION**
published in accordance with Art. 153(4) EPC

(43) Date of publication:
**10.04.2019 Bulletin 2019/15**

(21) Application number: **17806351.7**

(22) Date of filing: **15.05.2017**

(51) Int Cl.:
**H01L 31/048** $^{(2014.01)}$

(86) International application number:
**PCT/JP2017/018166**

(87) International publication number:
**WO 2017/208793 (07.12.2017 Gazette 2017/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **31.05.2016 JP 2016108199**
**26.12.2016 JP 2016250884**

(71) Applicant: **Panasonic Intellectual Property Management Co., Ltd.**
**Osaka-shi, Osaka 540-6207 (JP)**

(72) Inventors:
• **UEDA Takeshi**
**Chuo-ku**
**Osaka-shi, Osaka 540-6207**
**JAPAN (JP)**
• **KURIZOE Naoki**
**Chuo-ku**
**Osaka-shi, Osaka 540-6207 (JP)**

• **IKOMA Yoshimitsu**
**Chuo-ku**
**Osaka-shi, Osaka 540-6207 (JP)**
• **ANDO Hideyuki**
**Chuo-ku**
**Osaka-shi, Osaka 540-6207 (JP)**
• **YAMAZAKI Keiichi**
**Chuo-ku**
**Osaka-shi, Osaka 540-6207 (JP)**
• **SAKUMA Toshiyuki**
**Chuo-ku**
**Osaka-shi, Osaka 540-6207 (JP)**
• **FUKUSHIMA Atsushi**
**Chuo-ku**
**Osaka-shi, Osaka 540-6207 (JP)**
• **SUGIYAMA Motohiko**
**Chuo-ku**
**Osaka-shi, Osaka 540-6207 (JP)**

(74) Representative: **Müller-Boré & Partner**
**Patentanwälte PartG mbB**
**Friedenheimer Brücke 21**
**80639 München (DE)**

(54) **SOLAR CELL MODULE AND MANUFACTURING METHOD THEREOF**

(57) A solar cell module (100) includes a resin substrate (20), a first resin layer (30), photoelectric converters (10), and a second resin layer (40). The first resin layer (30) is provided under the resin substrate (20). The photoelectric converters (10) are provided under the first resin layer (30). The second resin layer (40) is provided under the first resin layer (30) to penetrate the first resin layer (30) or cover the first resin layer (30) from outside to be glued to the resin substrate (20). Adjacent photoelectric converters (10) are electrically connected to each other by a connecting member (14). A tensile modulus of elasticity of the first resin layer (30) is lower than that a tensile modulus of elasticity of the resin substrate and a tensile modulus of elasticity of the second resin layer (40).

EP 3 467 880 A1

# FIG. 2

**Description**

TECHNICAL FIELD

The present invention relates to a solar cell module and a manufacturing method thereof, and more particularly, to a solar cell module using a resin substrate and a manufacturing method thereof.

BACKGROUND ART

While glass substrates have been widely used for solar cell modules, resin substrates are recently used instead of the glass substrates to reduce the weight of the solar cell modules.

For example, Patent Literature 1 discloses a front sheet for a solar cell module having a base material layer that includes polycarbonate as the principal component. Such a configuration achieves a lightweight and high-impact resistant front sheet for a solar cell module.

Moreover, Patent Literature 1 discloses a filler layer formed of a sealant including a synthetic resin such as ethylene-vinyl acetate-based resin, to protect solar cells.

CITATION LIST

PATENT LITERATURE

Patent Literature 1: Japanese Patent Application Publication No. 2013-145807

SUMMARY OF INVENTION

Resin substrates however have hardness lower than that of glass substrates. When an object such as hail hits a resin substrate, the resin substrate is bent. When the object further hits the bent part, a local load is easily caused. The local load is transmitted to solar cells through the resin substrate and the sealant to have a risk to damage the solar cells. Accordingly, a high-impact resistant solar cell has been desired.

To improve the impact resistance, when a material having a low tensile modulus of elasticity is used as the sealant, the material absorbs the impact, and application of the impact to photoelectric converters can be prevented. The material having a low tensile modulus of elasticity is however easily deformed under the influence of vibration during transport, storage under a high-temperature environment, or the like. This has a possibility of causing separation of the photoelectric converters from the resin substrate or positional misalignment of the photoelectric converters in relation to the resin substrate.

The present invention has been made in view of such problems in the conventional technique. An object of the present invention is to provide a solar cell module that has high-impact resistance and an enhanced effect of holding the photoelectric converters firmly, and a manufacturing method thereof.

To solve the above described problems, a solar cell module according to a first aspect of the present invention includes a resin substrate, a first resin layer, photoelectric converters, and a second resin layer. The first resin layer is provided under the resin substrate. The photoelectric converters are provided under the first resin layer. The second resin layer is provided under the first resin layer to penetrate the first resin layer or cover the first resin layer from outside to be glued to the resin substrate. Adjacent photoelectric converters of the photoelectric converters are electrically connected to each other by a connecting member. A tensile modulus of elasticity of the first resin layer is lower than a tensile modulus of elasticity of the resin substrate and a tensile modulus of elasticity of the second resin layer.

A manufacturing method of a solar cell module according to a second aspect of the present invention is a manufacturing method of a solar cell module including a resin substrate, a first resin layer, photoelectric converters, and a second resin layer. The first resin layer is provided under the resin substrate. The photoelectric converters are provided under the first resin layer. The second resin layer is provided under the first resin layer to surround the entire periphery of the first resin layer in a plane view to be glued to the resin substrate. Adjacent photoelectric converters of the photoelectric converters are electrically connected to each other by a connecting member. A tensile modulus of elasticity of the first resin layer is lower than a tensile modulus of elasticity of the resin substrate and a tensile modulus of elasticity of the second resin layer. The manufacturing method the solar cell module includes a step of stacking the first resin layer having an area smaller than that of the second resin layer in a plane view over or under the second resin layer and gluing the resin substrate and the second resin layer together.

BRIEF DESCRIPTION OF DRAWINGS

[FIG. 1] FIG. 1 is a cross-sectional view of an example of a solar cell module according to a present embodiment.
[FIG. 2] FIG. 2 is a cross-sectional view of another example of the solar cell module according to the present embodiment.
[FIG. 3] FIG. 3 is a top view of the solar cell module shown in FIG. 1 with a resin substrate and a first resin layer removed.
[FIG. 4] FIG. 4 is a top view of another example of the solar cell module with the resin substrate and the first resin layer removed.
[FIG. 5] FIG. 5 is a top view of another example of the solar cell module with the resin substrate and the first resin layer removed.
[FIG. 6] FIG. 6 is a top view of another example of the solar cell module with the resin substrate and the first resin layer removed.
[FIG. 7] FIG. 7 is a top view of another example of the solar cell module without the resin substrate and the first resin layer.
[FIG. 8] FIG. 8 is a top view of another example of the solar cell module with the resin substrate and the first resin layer removed.
[FIG. 9] FIG. 9 is a top view of another example of the solar cell module with the resin substrate and the first resin layer removed.
[FIG. 10] FIG. 10 is a cross-sectional view of another example of the solar cell module according to the present embodiment.
[FIG. 11] FIG. 11 is a schematic diagram illustrating reflection of light at interfaces of resin layers.
[FIG. 12] FIG. 12 is a diagram illustrating external appearances of respective solar cell modules in examples 5 to 7.
[FIG. 13] FIG. 13 is a cross-sectional view of another example of the solar cell module according to the present embodiment.
[FIG. 14] FIG. 14 is a cross-sectional view of another example of the solar cell module according to the present embodiment.
[FIG. 15] FIG. 15 is a cross-sectional view of another example of the solar cell module according to the present embodiment.
[FIG. 16] FIG. 16 is a cross-sectional view of another example of the solar cell module according to the present embodiment.
[FIG. 17] FIG. 17 is a cross-sectional view of another example of the solar cell module according to the present embodiment.
[FIG. 18] FIG. 18 is a cross-sectional view of another example of the solar cell module according to the present embodiment.
[FIG. 19] FIG. 19 is a cross-sectional view of another example of the solar cell module according to the present embodiment.
[FIG. 20] FIG. 20 is a side view of the solar cell module in an example of a manufacturing method of the solar cell module according to the present embedment.

DESCRIPTION OF EMBODIMENTS

A solar cell module according to the present embodiment will be described in detail below with reference to the drawings. A ratio of dimensions is exaggerated for explanation and may be different from an actual ratio. For convenience, a rectangular coordinate system of x, y, and z axes is defined for explanation in the drawings where directions of arrows refer to a positive direction.

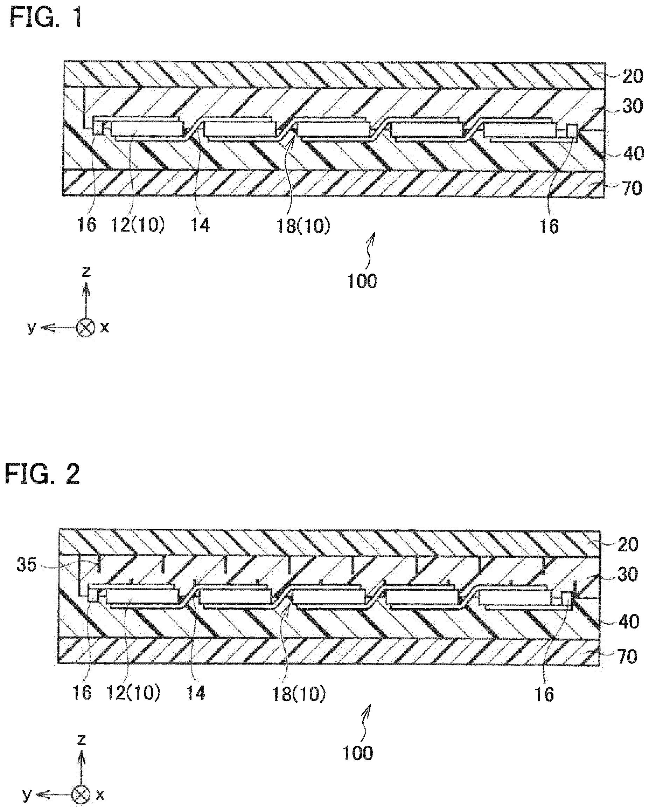

FIG. 1 illustrates an example of a solar cell module 100 according to the present embodiment in a cross-sectional view. The solar cell module 100 according to the present embodiment includes a resin substrate 20, a first resin layer 30, photoelectric converters 10, and a second resin layer 40. The first resin layer 30 is provided under the resin substrate 20. The photoelectric converters 10 are provided under the first resin layer 30. The second resin layer 40 is provided under the first resin layer 30 to penetrate the first resin layer 30 or cover the first resin layer 30 from outside to be glued to the resin substrate 20. Adjacent photoelectric converters 10 may be electrically connected to each other by connecting members 14. A tensile modulus of elasticity of the first resin layer 30 is lower than a tensile modulus of elasticity of the resin substrate 20 and a tensile modulus of elasticity of the second resin layer 40.
To increase the range of its use, such as an application to a building having a load bearing problem, weight reduction is needed for the solar cell module 100. Accordingly, using the resin substrate 20 as a substrate on a light receiving surface side of the solar cell modular 100 has been considered.

While the resin substrate 20 is lighter in weight than a glass substrate, when a local load caused by hail or the like is applied to the resin substrate 20, the local load may be transmitted to the photoelectric converters 10 through the sealant to damage the photoelectric converters 10.

In view of this situation, the solar cell module 100 according to the present embodiment has the resin substrate 20, the first resin layer 30, the photoelectric converters 10, and the second resin layer 40 in a predetermined arrangement. Moreover, the tensile modulus of elasticity of the first resin layer 30 is set lower than the tensile modulus of elasticity of each of the resin substrate 20 and the second resin layer 40. Accordingly, the solar cell module 100 according to the present embodiment absorbs the local load at the first resin layer 30, and the impact resistance of the solar cell module 100 can be thus improved.

Meanwhile, the first resin layer 30 having a low tensile modulus of elasticity is easy to be deformed. This has a possibility of causing separation of the photoelectric converters 10 in a stacking direction (z-axis direction) of the solar cell module 100 and positional misalignment of the photoelectric converters 10 in directions perpendicular to the stacking direction (x-axis direction and y-axis direction). In the present embodiment, the second resin layer 40 is thus arranged to penetrate the first resin layer 30 or cover the first resin layer 30 from outside to be glued to the resin substrate 20. The second resin layer 40, which has a high tensile modulus of elasticity, holds the first resin layer 30 firmly with respect to the resin substrate 20. Accordingly, the separation and the positional misalignment due to the first resin layer 30 can be prevented, and the effect of firmly holding the first resin layer 30 can be enhanced. These structural components will be described below.

(Resin substrate 20)

The resin substrate 20 is provided over a light receiving surface side of the solar cell module 100 to protect the surface of the solar cell module 100. For convenience, the resin substrate 20 may be called as a light receiving surface, and a back substrate 70 may be called as a surface opposite to the light receiving surface in the present embodiment. Another layer may be however provided on each of the surfaces as an external layer according to its use. The shape of the resin substrate 20 is any shape that functions to protect the surface of the solar cell module 100 and may be a circle, an ellipse, or a polygon including a rectangle according to its use.

A material used to form the resin substrate 20 is not limited and may be at least one selected from a group consisting of polyethylene (PE), polypropylene (PP), cyclic polyolefin, polycarbonate (PC), polymethyl methacrylate (PMMA), polytetrafluoroethylene (PTFE), polystyrene (PS), polyethylene terephthalate (PET), and polyethylene naphthalate (PEN). Among these materials, the resin substrate 20 more preferably includes polycarbonate (PC). Polycarbonate (PC), which is superior in impact resistance and translucency, is suitable for protecting the surface of the solar cell module 100.

The resin substrate 20 may have any thickness that functions to protect the surface of the solar cell module 100 and is preferably 0.1 mm to 15 mm, more preferably 0.5 mm to 10 mm. The resin substrate 20 having the thickness in such a range can protect the solar cell module 100 properly and transmit light to the photoelectric converters 10 efficiently.

The tensile modulus of elasticity of the resin substrate 20 is preferably, but not limited to, 1.0 GPa or greater and 10.0 GPa or less, more preferably 2.3 GPa or greater and 2.5 GPa or less. The resin substrate 20 having the tensile modulus of elasticity in such a range can protect the surface of the solar cell module 100 properly. The tensile modulus of elasticity is determined, for example, in the following formula (1) according to Japanese Industrial Standards JIS K7161-1 (Plastics-Determination of tensile properties, Part 1: General principles) at a test temperature of 25 °C and a test speed of 100 mm/minute.

[Math 1]

$$E_t = (\sigma_2 - \sigma_1) / (\varepsilon_2 - \varepsilon_1) \qquad (1)$$

where $E_t$ is tensile modulus of elasticity (Pa), $\sigma_1$ is stress (Pa) at strain $\varepsilon_1 = 0.0005$, and $\sigma_2$ is stress (Pa) at strain $\varepsilon_2 = 0.0025$.

A total luminous transmittance of the resin substrate 20 is preferably, but not limited to, 80% to 100%, more preferably 85% to 95%. The resin substrate 20 having the total luminous transmittance in such a range can transmit light to the photoelectric converters 10 efficiently. The total luminous transmittance is determined by a method such as JIS K7361-1 (Plastics-Determination of the total luminous transmittance of transparent materials, Part 1: Single beam instrument).

(First resin layer 30)

The first resin layer 30 protects the photoelectric converters 10 as a sealant. The first resin layer 30 is provided under the resin substrate 20. The first resin layer 30 is specifically arranged on a side of the resin substrate 20, the side being ahead in the negative direction of the z axis. The shape of the first resin layer 30 is not limited and may be a circle, an ellipse, or a polygon including a rectangle according to its use, as in the case of the resin substrate 20.

The first resin layer 30 may be in direct contact with the resin substrate 20 without another layer therebetween. Another layer such as an adhesive layer or a function layer may be provided between the first resin layer 30 and the resin substrate 20.

A material used to form the first resin layer 30 is not limited and may be various gel. The gel is not limited and classified into a type of gel including a solvent and a type of gel including no solvent. The gel including a solvent to be used may be hydrogel in which the dispersion medium is water, or organogel in which the dispersion medium is an organic solvent. Moreover, the gel including a solvent to be used may be any one of polymer gel in which a number-average molecular weight is 10000 or greater, oligomer gel in which number-average molecular weight is 1000 or greater and less than 10000, and low molecular gel in which number-average molecular weight is less than 1000. Among these types of gel, it is preferable for the first resin layer 30 to use polymer gel including a solvent or the gel including no solvent. This is because the polymer gel including a solvent and the gel including no solvent can hold the photoelectric converters 10 firmly and prevent the connecting members 14 from being cut due to movements of the photoelectric converters 10. Moreover, among the polymer gel including a solvent and the gel including no solvent, the first resin layer 30 preferably includes at least one selected from a group consisting of silicone gel, acrylic gel and urethane gel. This is because these types of gel, which have a low tensile modulus of elasticity, can relieve thermal stress and local load on the resin substrate 20 caused by changes in temperature and prevent damages of the photoelectric converters 10. Moreover, these types of gel can hold the photoelectric converters 10 more firmly and prevent the cut of the connecting members 14 due to movements of the photoelectric converters 10.

As shown in FIG. 2, the first resin layer 30 is preferably provided with slits 35 when the material to form the first resin layer 30 includes gel. That is, the first resin layer 30 preferably includes the gel, and the first resin layer 30 is provided with the slits 35. The first resin layer 30 provided with such slits 35 allows bubbles, which occur during long term use of the solar cell module 100 and get into the solar cell module 100 during the manufacture, to move through the slits 35. The bubbles thus can come out of the solar cell module 100 easily. Even if not coming out completely, the bubbles within the solar cell module 100 move through the slits 35 to disperse, and the size of the bubbles can be made smaller. The bubbles within the solar cell module 100 are thus hard to observe visually. Accordingly, reflection of sunlight and defects of external appearance due to the bubbles within the solar cell module 100 can be reduced.

The position of the slits 35 is not limited and may be on the surface of the first resin layer 30, for example. The slits 35 may be specifically provided on at least one of a surface of the first resin layer 30 toward the resin substrate 20 and a surface of the first resin layer 30 toward the second resin layer 40. To remove the bubbles easily, the slits 35 are preferably provided on the surface of the first resin layer 30 toward the resin substrate 20 and the surface of the first resin layer 30 toward the second resin layer 40, as shown in FIG. 2.

The size of each of the slits 35 in the stacking direction of the solar cell module 100 is preferably 5 % to 99 % of the thickness of the first resin layer 30. The slits 35 having the size in such a range can help the bubbles to come out easily and maintain the strength of the first resin layer 30. Moreover, the slits 35 having the size in such a range can further relieve the local load at the first resin layer 30. The size of each of the slits 35, which are provided on at least one side of the first resin layer 30, in the stacking direction of the solar cell module 100 is more preferably 10 % to 50 % of the thickness of the first resin layer 30. Moreover, the size of each of the slits 35 in directions perpendicular to the stacking direction of the solar cell module 100 (x-axis direction and y-axis direction) is not limited and may be determined in view of the removal of the bubbles or the strength of the first resin layer 30.

A direction of each of the slits 35 in the stacking direction of the solar cell module 100 is preferably parallel to the stacking direction of the solar cell module 100. The slits 35 having such a direction prevent reflection and refraction of the light caused by the slits 35 because incident directions of light are parallel to the direction of each of the slits 35. Accordingly, the slits 35 having such a direction can reduce loss of light caused by the slits 35. A direction of each of the slits, which is perpendicular to the stacking direction of the solar cell module 100 (x-axis direction and y-axis direction), is not limited and may be varied appropriately according to its use.

A distance between the slits 35 in a cross section horizontal to the stacking direction of the solar cell module 100 is preferably 0.1 mm to 10 mm, more preferably 0.5 mm to 2 mm, further preferably 0.8 mm to 1.2 mm. The slits 35 having the distance in such a range can improve the removal of the bubbles and maintain the strength of the first resin layer 30.

The tensile modulus of elasticity of the first resin layer 30 is preferably, but not limited to, 0.1 kPa or greater and less than 5 MPa, more preferably 1 kPa or greater and 1 MPa or less. The first resin layer 30 having a lower limit of the tensile modulus of elasticity in such a range can hold the photoelectric converters 10 firmly and prevent the cut of the connecting members 14 due to movements of the photoelectric converters 10. Meanwhile, the first resin layer 30 having an upper limit of the tensile modulus of elasticity in such a range can effectively relieve thermal stress and local load on the resin substrate 20 caused by changes in temperature.

The thickness of the first resin layer 30 is preferably, but not limited to, 0.1 mm or greater and 10 mm or less, more preferably 0.2 mm or greater and 1.0 mm or less. The first resin layer 30 having the thickness in such a range can protect the photoelectric converters 10 properly and transmit light to the photoelectric converters 10 efficiently.

A total luminous transmittance of the first resin layer 30 is preferably, but not limited to, 60 % to 100 %, more preferably 70 % to 95 %. Moreover, the total luminous transmittance of the first resin layer 30 is further preferably 80 % to 95 %. The first resin layer 30 having the total luminous transmittance in such a range can transmit light to the photoelectric converters 10 efficiently.

(Photoelectric converter 10)

The photoelectric converters 10 are any photoelectric converters that convert light energy into electrical energy. In the present embodiment, the photoelectric converters 10 thus may be solar cells 12 or a solar cell string 18. A combination of the solar cell strings 18 and a connecting wire 16 may be used as the photoelectric converters 10.

The photoelectric converters 10 are provided under the first resin layer 30. Relationship in arrangement between the photoelectric converters 10 and the first resin layer 30 is any relationship in which the photoelectric converters 10 are provided vertically lower than the first resin layer 30. The photoelectric converters 10 in such an arrangement can relieve the impact of an object such as hail at the first resin layer 30 and thus prevent damages of the photoelectric converters 10. Accordingly, the photoelectric converters 10 may or may not be in contact with the first resin layer. The photoelectric converters 10 may be arranged to be in contact with at least a part of the first resin layer 30 or the first resin layer 30 may be arranged to cover the entire photoelectric converters 10. With such an arrangement, an uneven structure on the surface of the photoelectric converters 10, which is due to electrical conducting arrangement and the like, is covered by the first resin layer 30, and the first resin layer 30 can be adhered to the photoelectric converters 10. Accordingly, the occurrence of bubbles at the surfaces of the photoelectric converters 10 due to changes in temperature can be reduced.

Examples of the solar cells 12 include a silicon-type solar cell, a compound-type solar cell, and an organic-type solar cell. Examples of the silicon-type solar cell include a single crystalline silicon solar cell, a polycrystalline silicon solar cell, a microcrystalline silicon solar cell, and an amorphous silicon solar cell. Examples of the compound-type solar cell include a GaAs solar cell, a CIS solar cell, a CIGS solar cell, and a CdTe solar cell. Examples of the organic-type solar cell includes a dye sensitized solar cell, and an organic thin-film solar cell. Moreover, a heterojunction solar cell and a multijunction solar cell may be used as the solar cells 12.

The shape of each of the solar cell 12 is not limited and may be in a flat plate shape having a front portion, a back portion, and side portions. The front portion here is, for example, one surface on the light receiving surface side of the solar cell 12, which faces the resin substrate 20. The back portion is, for example, the other surface on a side opposite to the light receiving surface side of the solar cell 12, which faces the back substrate 70. The side portions are surfaces sandwiched between the front and the back to form the sides. Specific examples of the shape of each of the solar cell 12 include a rectangular flat plate, but the shape is not limited.

Adjacent solar cells 12 may be electrically connected to each other by the connecting members 14 to form a solar cell string 18. In FIG. 1, the solar cell string 18 is formed by electrically connecting a busbar electrode on the light receiving surface side of one of adjacent solar cells 12 and a busbar electrode on a side opposite to the light receiving surface side of the other of the adjacent solar cells 12 by the connecting member 14. In addition, the connecting wire 16 may electrically connect adjacent two solar cell strings 18 each other.

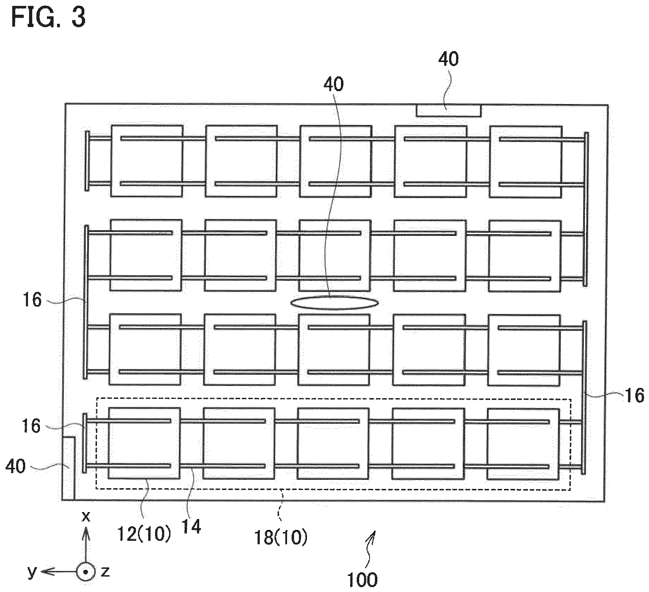

FIG. 3 illustrates that five solar cells 12 arranged in the y-axis direction are connected in series by the connecting members 14 to form one solar cell string 18, as an example. Moreover, FIG. 3 illustrates that four solar cell strings 18 arranged parallel in the x-axis direction are electrically connected by the connecting wires 16, as an example. While FIG. 3 illustrates an example, the number, arrangement and the like of the solar cells 12 are not limited.

The connecting member 14 has any shape and includes any material that electrically connect the solar cells 12 each other. For example, the connecting member 14 may be a tab lead formed of a strip of metal foil. A material used to form the connecting members 14 may be, for example, aluminum, copper or the like. The connecting member 14 preferably includes aluminum. Using aluminum for the connecting member 14 can prevent decomposition of the first resin layer 30 and the second resin layer 40 in contact with the connecting member 14, and discoloration of the resin forming these layers, which are caused by a catalytic reaction of a metal forming the connecting member 14. In addition, the connecting member 14 including non-plated aluminum can prevent the discoloration of the resin more reliably than the connecting member 14 in which copper foil is plated with silver. Coated solder, coated silver or the like may be used for the connecting member 14.

Resin may be used to connect the connecting member 14 and the busbar electrodes. The resin may be either conductive or non-conductive. When non-conductive resin is used, the tab leads and the busbar electrodes are directly connected with each other to be electrically connected. Soldering may be used instead of the resin.

Although omitted in the drawing, a plurality of finger electrodes extending parallel to each other in the x-axis direction may be provided both on a surface on the light receiving surface side and a surface on the side opposite to the light receiving surface side of each of the solar cells 12. The busbar electrodes extending in the y-axis direction may be orthogonally connected with the plurality of finger electrodes.

(Second resin layer 40)

The second resin layer 40 protects the photoelectric converters 10 as a sealant, as in the case of the first resin layer 30. The second resin layer 40 is provided under the first resin layer 30. The second resin layer 40 is specifically arranged on a side of the first resin layer 30, the side ahead in the negative direction of the z axis. The shape of the second resin layer 40 is not limited and may be a circle, an ellipse, or a polygon including a rectangle according its use, as in the case of the resin substrate 20.

FIGS. 3 to 9 show respective arrangements of the second resin layer 40 in a plane view, where the resin substrate 20 and the first resin layer 30 are removed from the solar cell module 100. As shown in FIGS. 1 and 3, in the present embodiment, the second resin layer 40 is arranged to penetrate the first resin layer 30 or cover the first resin layer 30 from outside to be glued to the resin substrate 20. In FIG. 3, the second resin layer 40 is arranged to be glued to the resin substrate 20 at three points. It is however only required that the second resin layer 40 is arranged to be glued to the resin substrate 20 at least at one point. FIG. 1 illustrates a cross section at one point among the three points of the second resin layer shown in FIG. 3, as an example. FIG. 1 illustrates an example of an arrangement where the second resin layer 40 covers the first resin layer 30 from outside to be glued to the resin substrate 20.

In the present embodiment, the tensile modulus of elasticity of the first resin layer 30 is lower than the tensile modulus of elasticity of each of the resin substrate 20 and the second resin layer 40. The first resin layer 30 is thus easy to be deformed under the influence of vibration during transport or storage under a high-temperature environment of the solar cell module 100. Accordingly, separation of the photoelectric members 10 and the second resin layer 40 from the resin substrate 20 easily occurs in horizontal directions (x-axis direction and y-axis direction) of the solar cell module 100. Moreover, positional misalignment of the photoelectric members 10 and the second resin layer 40 with respect to the resin substrate 20 easily occurs in the stacking direction (z-axis direction) of the solar cell module 100. In the present embodiment, however, at least a part of the second resin layer 40 is arranged to penetrate the first resin layer 30 or cover the first resin layer 30 from outside to be glued to the resin substrate 20. The second resin layer 40 having a comparative higher tensile modulus of elasticity is thus fixed to the resin substrate 20. As a result, the separation and the positional misalignment of the photoelectric converters 10 and the second resin layer 40 due to the first resin layer 30 can be prevented. When various types of gel are used as the first resin layer 3, the separation between the resin substrate 20 and the first resin layer 30 caused by the low adhesiveness of the gel can be also prevented. Moreover, adhesiveness per unit between the resin substrate 20 and the first resin layer 30 is preferably lower than adhesiveness per unit between the resin substrate 20 and the second resin layer 40.

A state of the second resin layer 40 arranged and glued to the resin substrate 20 is not limited, and, for example, the second resin layer 40 may be arranged in direct contact with the resin substrate 20 without interposing another layer therebetween. Alternatively, the second resin layer 40 may be arranged to be glued to the resin substrate 20 by interposing another layer therebetween. Examples of another layer include a function layer, such as an adhesive layer and a protective layer. The function layer may be a single layer or a plurality of layers, and it is only required that at least a part of the second resin layer 40 is arranged to be fixed to the resin substrate 20.

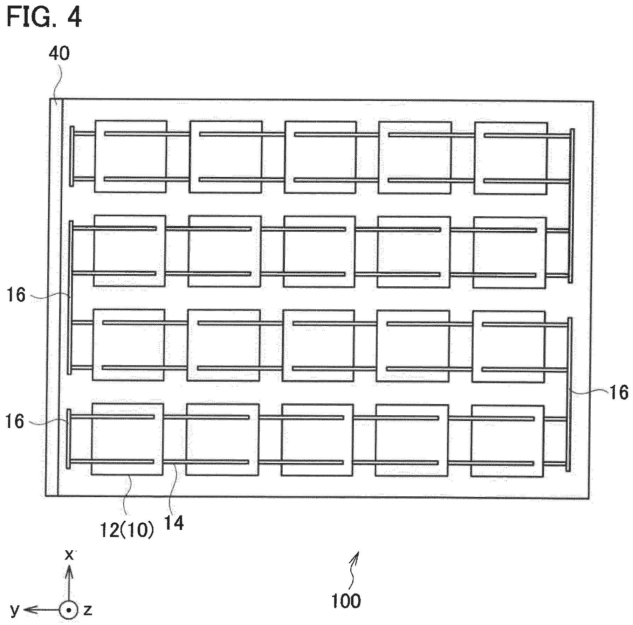

As shown in FIG. 4, in the present embodiment, the second resin layer 40 may be arranged to cover the entire edge, of the first resin layer 30 from outside to be glued to the resin substrate 20, the entire edge in at least one direction in a plane view. When the first resin layer 30 is in a substantially polygonal shape having at least three or more sides in a plane view for example, the entire edge in one direction here may be one side of the polygon. That is, in the present embodiment, the first resin layer 30 may be in a substantially polygonal shape having at least three or more sides in a plane view, and the second resin layer 40 may be arranged to cover at least one side of the first resin layer 30 from outside to be glued to the resin substrate 20. When having a complex shape, the first resin layer 30 is regarded as having a substantially rectangular shape in a plane view, and a side thereof may be also set as the entire edge in one direction. In this way, the second resin layer 40 is arranged to cover the entire edge, which is in at least one direction, of the first resin layer 30 from outside. Accordingly, a contact area of the second resin layer 40 with the resin substrate 20 can be increased, and the second resin layer 40 can be fixed more firmly to the resin substrate 20. Consequently, the separation and the positional misalignment of the photoelectric converters 10 and the second resin layer 40 due to the first resin layer 30 can be reduced.

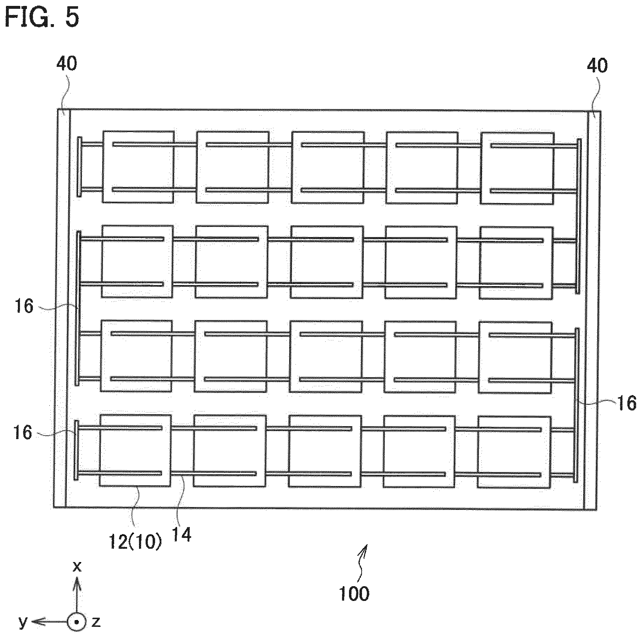

As shown in FIG. 5, in the present embodiment, adjacent photoelectric converters 10 may be electrically connected to each other by the connecting members 14. The second resin layer 40 may be arranged to sandwich the first resin layer 30 therebetween at the entire edge of both ends of the first resin layer 30 to be glued to the resin substrate 20, the both ends extending along a direction perpendicular (x-axis direction) to the connecting direction of the photoelectric converters 10 connected by the connecting members 14. That is, when the first resin layer 30 is regarded as having a substantially rectangular shape in a plane view, two edges of the second resin layer 40, which face each other, may sandwich the first resin layer 30 therebetween from both sides of the first resin layer 30. Consequently, the separation and the positional misalignment of the photoelectric converters 10 and the second resin layer 40 due to the first resin layer 30 can be further improved. Moreover, the second resin layer 40 can prevent movements of the first resin layer 30 in the connecting direction of the connecting members 14 (y-axis direction), and thus a fatigue failure and the like of the connecting members 14 derived from thermal contraction of the resin substrate 20 can be prevented.

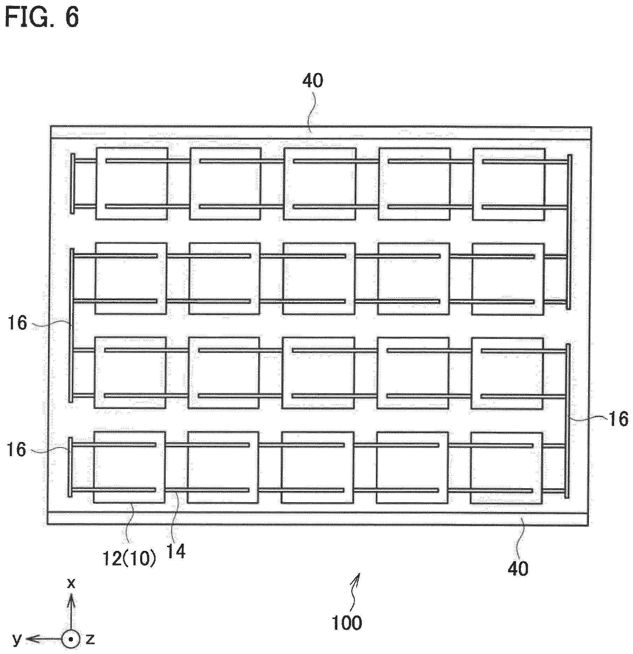

As shown in FIG. 6, in the present embodiment, adjacent photoelectric converters 10 may be electrically connected to each other by the connecting members 14. The second resin layer 40 may be arranged to sandwich the first resin layer 30 therebetween at the entire edge of both ends of the first resin layer 30 to be glued to the resin substrate 20, the both ends extending along the connecting direction of the photoelectric converters 10 connected by the connecting members 14 (y-axis direction). That is, when the first resin layer 30 is regarded as having a substantially rectangular shape in a plane view, two edges of the second resin layer 40, which face each other, can sandwich the first resin layer 30 therebetween from both sides of the first resin layer 30. Consequently, the separation and the positional misalignment of the photoelectric converters 10 and the second resin layer 40 due to the first resin layer 30 can be further prevented. Moreover, the second resin layer 40 can prevent movements of the first resin layer 30 in a direction perpendicular (x-axis direction) to the connecting direction of the connecting members 14 and thus prevent positional alignment of the photoelectric converters 10 in the x-axis direction.

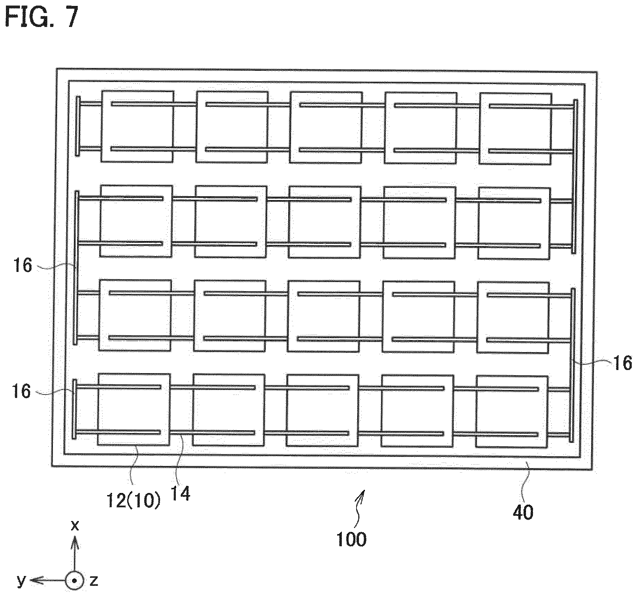

As shown in FIG. 7, in the present embodiment, the second resin layer 40 is preferably arranged to surround the entire periphery of the first resin layer 30 in a plane view to be glued to the resin substrate 20. An area where the second resin layer 40 is glued to the resin substrate 20 is increased, and the separation and the positional misalignment of the photoelectric converters 10 and the second resin layer 40 due to the first resin layer 30 can be further prevented. Meanwhile, the first resin layer 30 having a low tensile modulus of elasticity comparatively has a low oxygen transmission rate and a low water vapor transmission rate. Oxygen and water included in the outside air pass through the first resin layer 30 to have a bad effect such as rust on the photoelectric converters 10 and the connecting members 14. The second resin layer 40 however includes a concave portion to receive the first resin layer 30 and the photoelectric converters 10 and surrounds the entire periphery of the first resin layer 30. The first resin layer 30 is thus isolated from the outside air, and reaching of the oxygen and water to the photoelectric converters 10, the connecting members 14 and the like can be prevented. Consequently, the bad effect by oxygen and water on the photoelectric converters 10 and the connecting members 14 can be lessened. When various types of gel are used as the first resin layer 30, the gel have no direct contact with the outside air, and a change in quality and deterioration can be prevented. For example, when gel including a solvent is used as the first resin layer 30, the second resin layer 40 can prevent volatilization of the solvent and thus prevent the contraction of the gel. Moreover, when silicone gel is used as the first resin layer 30, dispersion of siloxane included in the silicone gel to the outside air can be prevented, which causes the contraction of the first resin layer 30 and subsequent separation at the interface of the first resin layer 30.

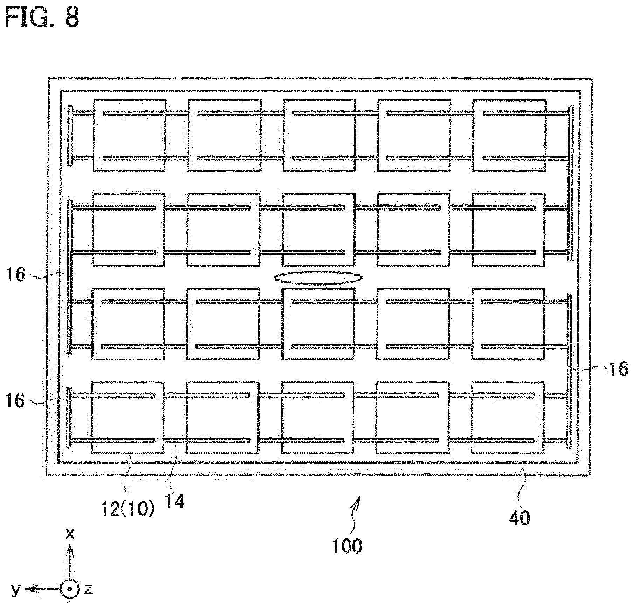

As shown in FIG. 8, in the present embodiment, the second resin layer 40 preferably is arranged to penetrate the first resin layer 30 and surround the entire periphery of the first resin layer 30 in a plane view to be glued to the resin substrate 20. The photoelectric converters 10 and the connecting members 14 can be protected from the outside air, and the separation and the positional alignment due to the first resin layer 30 can be further prevented, accordingly.

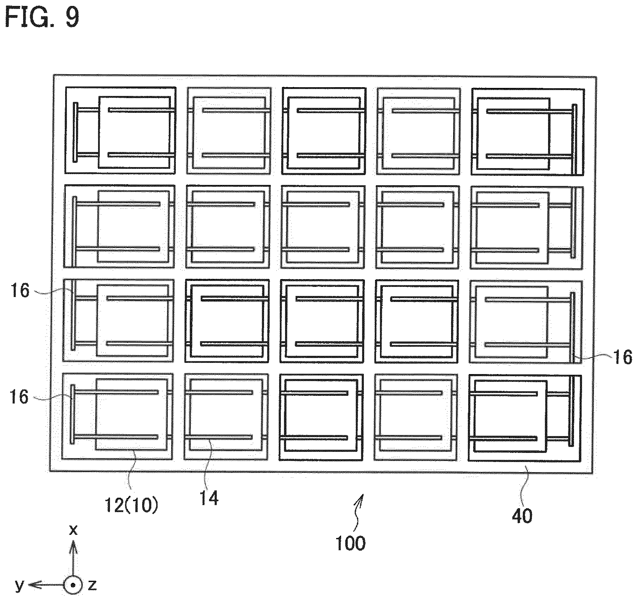

As shown in FIG. 9, in the present embodiment, when the photoelectric converters 10 are provided over the second resin layer 40, the second resin layer 40 is preferably arranged to surround the each entire periphery of two or more photoelectric converters 10 in a plane view to be glued to the resin substrate 20. The photoelectric converters 10 and the connecting members 14 can be further protected from the outside air, and the separation and the positional misalignment due to the first resin layer 30 can be further prevented. While the second resin layer surrounds each of the photoelectric converters 10 in FIG. 9, the second resin layer may surround the periphery of two or more photoelectric converters 10 as a group, for example.

The thickness of the second resin layer 40 is preferably, but not limited to, 0.1 mm or greater and 10 mm or less, more preferably 0.2 mm or greater and 1.0 mm or less. The second resin layer 40 having a thickness in such a range can protect the photoelectric converters 10 properly from a thermal shock.

The second resin layer 40 may be in direct contact with the first resin layer 30 without another member therebetween. Alternatively, another layer such as an adhesion layer or a function layer may be provided between the second resin layer 40 and the first resin layer 30. A third resin layer 50 may be specifically provided between the first resin layer 30 and the second resin layer 40 as will be described below.

A material used to form the second resin layer 40 is not limited and may be at least one selected from a group consisting of thermoplastic resin, such as an ethylene vinyl acetate copolymer (EVA), polyvinyl butyral (PVB), polyethylene terephthalate (PET), polyolefin (PO) and polyimide (PI), and thermosetting resin, such as epoxy, urethane and polyimide. Modified resin may be used for these types of resin, and a combination thereof may be used. In particular, the second resin layer 40 preferably includes an ethylene vinyl acetate copolymer (EVA) or polyolefin (PO). Moreover, the material used to form the second resin layer 40 is preferably selected appropriately depending on materials to form the third resin layer 50 and a fourth resin layer 60, which will be described below. In view of protecting the photoelectric converters 10 from water in the outside, a water vapor transmission rate of the second resin layer 40 is preferably lower than that of the first resin layer 30. The water vapor transmission rate is determined, for example, in accordance with an infrared detection sensor method prescribed in Annex B of JIS K7129:2008 (Plastics Film and sheeting. Determination of water vapor transmission rate (Instrumental method)).

The tensile modulus of elasticity of the second resin layer 40 is preferably, but not limited to, 0.005 GPa to 0.5 GPa, more preferably 0.01 GPa to 0.25 GPa. The second resin layer 40 having such a lower limit of the tensile modulus of elasticity can prevent the positional misalignment of the photoelectric converters 10. Moreover, the second resin layer 40 having such an upper limit of the tensile modulus of elasticity can prevent damage of the photoelectric converters 10 and the connecting members 14 due to thermal contraction of the second resin layer 40.

The solar cell module 100 according to the present embodiments may be provided with the third resin layer 50, the fourth resin layer 60, the back substrate 70, a low-heat expansion layer 80, a lubricant layer 90 and an oxygen barrier layer 95, and a not shown frame and the like, within a scope not ruining the effect of the present embodiment. The frame protects the edge portion of the solar cell module 100 and is used when the solar cell module 10 is installed on a roof or the like.

(Third resin layer 50)

The third resin layer 50 protects the photoelectric converters 10 as a sealant, as in the case of the first resin layer 30 and the second resin layer 40. The shape of the third resin layer 50 is not limited and may be a circle, an ellipse, a polygon including a rectangle according to its use, as in the case of the second resin layer 40.

The material used to form the third resin layer 50 is not limited and may be at least one selected from the group consisting of thermoplastic resin, such as an ethylene vinyl acetate copolymer (EVA), polyvinyl butyral (PVB), polyethylene terephthalate (PET), polyolefin (PO) and polyimide (PI), and thermosetting resin, such as epoxy, urethane and polyimide. Modified resin may also be used for these types of resin, and a combination thereof may also be used. In particular, the third resin layer 50 preferably includes polyolefin (PO). In this case, the second resin layer 40 preferably includes an ethylene vinyl acetate copolymer (EVA).

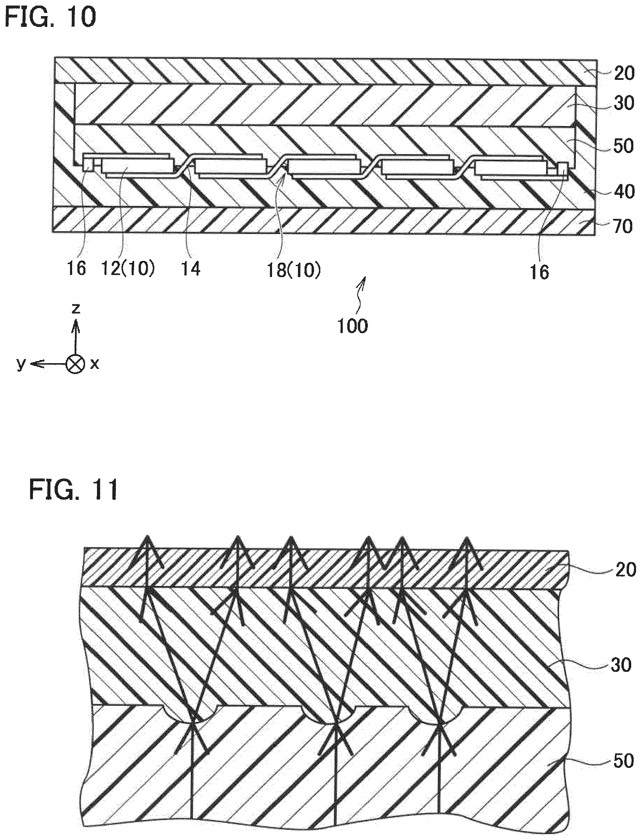

As shown in FIG. 10, the solar cell module 100 may further include the third resin layer 50 provided under the first resin layer 30 and over the second resin layer 40. The photoelectric converters 10 may be provided under the third resin layer 50 and over the second resin layer 40. Moreover, a tensile modulus of elasticity of the third resin layer 50 may be lower than the tensile modulus of elasticity of the second resin layer 40. The tensile modulus of elasticity of the first resin layer 30 is preferably lower than that of the third resin layer 50. Provision of the third resin layer having such properties can enhance thermal shock resistance of the solar cell module 100 and prevents the connecting members 14 from being cut due to changes in temperature.

That is, although a resin substrate is lighter than a glass substrate, the resin substrate has a coefficient of linear expansion higher than that of the glass substrate and thus receives large influence of thermal stress due to thermal contraction. The thermal stress here is expressed as follows:
[Math 2]

$$\sigma = E\alpha\Delta T \qquad (2)$$

where $\sigma$ is thermal stress (Pa), E is tensile modulus of elasticity (Young's modulus) (Pa), $\alpha$ is coefficient of linear expansion, and $\Delta T$ is difference in temperature changes (K).

When the resin substrate thermally contracts due to changes in temperature, the sealant thermally contracts, accordingly. As described above, the tensile modulus of elasticity of the first resin layer 30 here is lower than that of each of the resin substrate 20 and the second resin layer 40. The first resin layer 30 thus can relieve the stress due to the thermal contraction of the resin substrate 20. In addition, when the tensile modulus of elasticity of the third resin layer 50 is lower than that of the second resin layer 40, the third resin layer 50 can relieve the thermal stress of the resin substrate 20 that is not relieved by the first resin layer 30. The cut of the connecting members 14 due to the thermal contraction of the resin substrate 20 can be further prevented, and the thermal shock resistance of the solar cell module 100 can be improved.

The thermal shock resistance when the tensile modulus of elasticity of the resin layer between the first resin layer and the photoelectric converters is set lower than that of the resin layer between the photoelectric converters and the back substrate was evaluated in the following examples. The present embodiment is however not limited to these examples.

[Example 1]

A solar cell module was manufactured by stacking a resin substrate having a thickness of 1 mm, a first resin layer having a thickness of 1 mm, a third resin layer having a thickness of 0.6 mm, photoelectric converters, a second resin layer having a thickness of 0.6 mm, and a back substrate having a thickness of 2 mm in sequence from above and compressing and heating at 145 °C under reduced pressure. Polycarbonate was used for the resin substrate. Gel was used for the first resin layer. Polyolefin (PO) (tensile modulus of elasticity of 20.9 MPa at 25 °C) was used for the third resin layer. Solar cells were used for the photoelectric converters. An ethylene vinyl acetate copolymer (EVA) (tensile modulus of elasticity of 30.5 MPa at 25 °C) was used for the second resin layer. Carbon fiber-reinforced plastic (CFRP) (coefficient of linear expansion of $2.5 \times 10^{-6} K^{-1}$) was used for the back substrate.

[Example 2]

A solar cell module was manufactured in the same way as in Example 1 except for using glass (coefficient of linear expansion of $9 \times 10^{-6} K^{-1}$) for the back substrate.

[Example 3]

A solar cell module was manufactured in the same way as in Example 1 except for using an ethylene vinyl acetate copolymer (EVA) (tensile modulus of elasticity of 30.5 MPa at 25 °C) for the third rein layer.

[Example 4]

Glass (coefficient of linear expansion of $9 \times 10^{-6} K^{-1}$) was used for the back substrate. An ethylene vinyl acetate copolymer (EVA) (tensile modulus of elasticity of 30.5 MPa at 25 °C) was used for the third resin layer. Except for using these materials, a solar cell module was manufactured in the same way as in Example 1.

(Thermal shock resistance)

A test for the thermal shock resistance was performed under the following test conditions in accordance with a temperature cycle test of JIS C8990:2009 (IEC61215:2005) (Crystalline silicon terrestrial photovoltaic (PV) modules-Design qualification and type approval). That is, the solar cell module in each example was placed in a test chamber, and the temperature of the solar cell module was changed cyclically between -40 °C (± 2 °C) and 85 °C (± 2 °C). The connecting members to connect solar cells each other were visually observed after the temperature cycle test was performed for 25 cycles, 50 cycles, and 200 cycles. A solar cell module having no connecting member cut after 200 cycles was judged as "200 or more", a solar cell module having no connecting member cut after 50 cycles and having a connecting member cut after 200 cycles as "50 or more and less than 200", a solar cell module having no connecting member cut after 25 cycles and having a connecting member cut after 50 cycles as "25 or more and less than 50", and a solar cell module having a connecting member cut after 25 cycles as "less than 25". Speed of change in temperature between the lower limit and the upper limit was set to about 1.4 °C / hour, a period of time to keep the lower limit temperature was set to 60 minutes, a period of time to keep the upper limit temperature was set to 1 hour and 20 minutes, and a period of time for one cycle was set to 5 hours and 20 minutes. The temperature cycle test was performed at least three times.

[Table 1]

| | Third Resin Layer | | Second Resin Layer | | Back Substrate | Evaluation Result |
|---|---|---|---|---|---|---|
| | Material | Tensile Modulus of Elasticity (MPa) | Material | Tensile Modulus of Elasticity (MPa) | Material | |
| Example 1 | PO | 20.9 | EVA | 30.5 | CFRP | 200 or more |
| Example 2 | PO | 20.9 | EVA | 30.5 | Glass | 200 or more |
| Example 3 | EVA | 30.5 | EVA | 30.5 | CFRP | 200 or more |

(continued)

| | Third Resin Layer | | Second Resin Layer | | Back Substrate | Evaluation Result |
|---|---|---|---|---|---|---|
| | Material | Tensile Modulus of Elasticity (MPa) | Material | Tensile Modulus of Elasticity (MPa) | Material | |
| Example 4 | EVA | 30.5 | EVA | 30.5 | Glass | 50 or more and less than 200 |

The thermal shock resistance in each example was evaluated through the temperature cycle test. As shown in Table 1, the solar cell modules in Examples 1 to 3 had no connecting member cut after 200 cycles. Meanwhile, the solar cell module in Example 4 had no connecting member cut after 50 cycles but had a connecting member cut after 200 cycles.

The result of Examples 1 to 4 shows that the thermal shock resistance of the solar cell module 100 is improved when the tensile modulus of elasticity of the third resin layer 50 is lower than that of the second resin layer 40. The third resin layer 50 seems to relieve the thermal stress of the resin substrate 20. In the present embodiment, the tensile modulus of elasticity of the resin layer between the first resin layer 30 and the photoelectric converters 10 is thus preferably lower than that of the resin layer between the photoelectric converters 10 and the back substrate 70. Specifically, when the solar cell module 100 does not include the third resin layer 50 and the fourth resin layer 60, which will be described below, and the photoelectric converters 10 are provided over the second resin layer 40, it is required that the tensile modulus of elasticity of the first resin layer 30 is lower than that of the second resin layer 40. When the solar cell module 100 includes the third resin layer 50, which will be described below, the tensile modulus of elasticity of the third resin layer 50 is preferably lower than that of the second resin layer 40. When the solar cell module 100 includes the fourth resin layer 60, which will be described below, the tensile modulus of elasticity of the second resin layer 40 is preferably lower than that of the fourth resin layer 60.

The tensile modulus of elasticity of the resin layer between the first resin layer 30 and the photoelectric converters 10 is preferably lower than that of the resin layer between the photoelectric converters 10 and the back substrate 70 over a temperature range between -40 °C and +90 °C. This allows the thermal stress of the resin layer between the first resin layer 30 and the photoelectric converters 10 to be smaller than that of the resin layer between the photoelectric converters 10 and the back substrate 70 at any temperature, which is preferable in further relieving the thermal stress of the resin substrate. The tensile modulus of elasticity of polyolefin used in Example 1 at temperatures of -40 °C, +25 °C, and +90 °C were 536 MPa, 20.9 MPa, and 0.068 MPa, respectively. The tensile modulus of elasticity of the ethylene vinyl acetate copolymer (EVA) used in Example 1 at temperatures of -40 °C, +25 °C, and +90 °C were 1570 MPa, 30.5 MPa, and 0.69 MPa, respectively.

In the solar cell module 100 according to the present embodiment, a difference in refractive indices between the first resin layer 30 and the resin layer adjacent to the first resin layer 30 and provided over the photoelectric converters 10 is preferably 0.1 or less. More specifically, a difference in refractive indices between the first resin layer 30 and the rein layer adjacent to the first resin layer 30 on a side opposite to the resin substrate 20 and provided over the photoelectric converters 10 is preferably 0.1 or less. For example, in the embodiment shown in FIG. 10, when the tensile modulus of elasticity of the first resin layer 30 is lower than that of the third resin layer 50, a difference in refractive indices between the first resin layer 30 and the third resin layer 50 is preferably 0.1 or less. Setting the difference in refractive indices in such a range can improve the external appearance of the solar cell module 100. Specifically, in the top view of the solar cell module 100, the circular pattern of light is hard to observe visually. The difference in refractive indices between the first resin layer 30 and the resin layer adjacent to the first resin layer 30 is more preferably 0.05 or less.

The reason for the circular pattern of light is considered as follows. The tensile modulus of elasticity of the first resin layer 30 is lower than that of the third resin layer 50, and thus the impact resistance of the solar cell module 100 can be improved. The first resin layer 30 is however easily deformed to have unevenness when the solar cell module 100 is formed by lamination while heated, which is because the first resin layer 30 has flexibility compared to the third rein layer 50. The first resin layer 30 easily has such unevenness when the solar cell module 100 is formed by lamination particularly in a vacuum. When such unevenness is caused, light refracts at an interface between the first resin layer 30 and the resin layer adjacent to the first resin layer 30, as shown in arrows in FIG. 11. This refraction of light is considered to cause the circular pattern of light and have influence on the external appearance of the solar cell module 100.

The external appearance of the solar cell module 100 when the difference in refractive indices between the first resin layer 30 and the resin layer adjacent to the first resin layer 30 is 0.1 or less was evaluated in the following examples. The present embodiment is however not limited to these examples.

[Example 5]

A solar cell module was manufactured by stacking a resin substrate having a thickness of 1 mm, a first resin layer having a thickness of 1 mm, a third resin layer having a thickness of 0.6 mm, photoelectric converters, a second resin layer having a thickness of 0.6 mm, and a back substrate having a thickness of 2 mm in sequence from above and compressing and heating at 145 °C under reduced pressure. Polycarbonate (PC) was used for the resin substrate. Acrylic gel having a refractive index of 1.49 to 1.53 was used for the first resin layer. An ethylene vinyl acetate copolymer (EVA) (tensile modulus of elasticity of 30.5 MPa) having a refractive index of 1. 54 was used for the third resin layer. Solar cells were used for photoelectric converters. The ethylene vinyl acetate copolymer (EVA) (tensile modulus of elasticity of 30.5 MPa) was used for the second resin layer. Carbon fiber-reinforced plastic (CFRP) was used for the back substrate. At that time a difference in refractive indices between the first resin layer and the third resin layer was 0.01 to 0.05.

[Example 6]

A solar cell module was manufactured in the same way as in Example 5 except for using silicone gel (tensile modulus of elasticity of 28 kPa) having a refractive index of 1.43 for the first resin layer instead of the acrylic gel and newly providing a different resin layer between the first resin layer and the third resin layer. Acrylic gel having a refractive index of 1.49 to 1.53 was used for the different resin layer. At that time, a difference in refractive indices between the first resin layer and the different resin layer was 0.06 to 0.10.

[Example 7]

A solar cell module was manufactured in the same way as in Example 5 except for using silicone gel (tensile modulus of elasticity of 28 kPa) having a refractive index of 1.43 instead of the acrylic gel for the first resin layer. At that time, a difference in refractive indices between the first resin layer and the third resin layer was 0.11.

[Example 8]

A solar cell module was manufactured in the same way as in Example 6 except for using polyethylene terephthalate (PET) having a refractive index of 1.60 for the different layer instead of the acrylic resin. At that time, a difference in refractive indices between the first resin layer and the different resin layer was 0.17.

[Example 9]

A solar cell module was manufactured in the same way as in Example 6 except for using polyvinylidene chloride (PVDC) having a refractive index of 1.60 to 1.63 for the different layer instead of the acrylic resin. At that time, a difference in refractive indices between the first resin layer and the different resin layer was 0.17 to 0.20.

[Example 10]

A solar cell module was manufactured in the same way as in Example 7 except for using glass for the resin substrate instead of the polycarbonate (PC). At that time, a difference in refractive indices between the first resin layer and the third resin layer was 0.11.

[Example 11]

A solar cell module was manufactured in the same way as in Example 7 except for not arranging the third resin layer of the ethylene vinyl acetate copolymer (EVA).

[Evaluation]

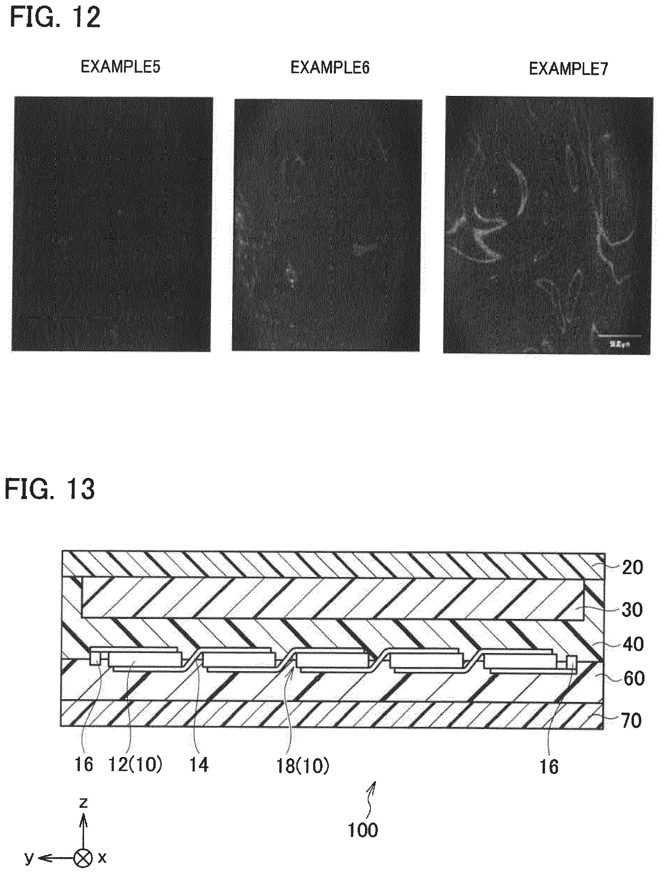

External appearances of the solar cell modules manufactured in respective examples were evaluated through visual inspection. Table 2 shows the result. FIG. 12 illustrates external appearances of the solar cell modules in Examples 5 o 7 for reference.

[Table 2]

| | Substrate | First Resin Layer | Different Resin Layer | Third Resin Layer | Difference in Refractive Indices | External Appearance |
|---|---|---|---|---|---|---|
| Example 5 | PC | Acrylic gel | - | EVA | 0.01~0.05 | Good |
| Example 6 | PC | Silicone gel | Acrylic gel | EVA | 0.06~0.10 | Satisfactory |
| Example 7 | PC | Silicone gel | - | EVA | 0.11 | Circular pattern |
| Example 8 | PC | Silicone gel | PET | EVA | 0.17 | Circular pattern |
| Example 9 | PC | Silicone gel | PVDC | EVA | 0.17~0.20 | Circular pattern |
| Example 10 | Glass | Silicone gel | - | EVA | 0.11 | Good |
| Example 11 | PC | Silicone gel | - | - | - | Good |

As shown in FIG. 12, the circular pattern of light was not recognized on the external appearance of the solar cell module in Example 5. This seems to be because a difference in refractive indices between the first resin layer and the third resin layer is 0.05 or less. As shown in FIG. 12, the circular pattern of light was hardly recognized on the external appearance of the solar cell module in Example 6. This seems to be because a difference in refractive indices between the first resin layer and the different rein layer was 0.1 or less.

Meanwhile, as shown in FIG. 12, the circular pattern of light was recognized on the solar cell module in Example 7. This seems to be because a difference in refractive indices between the first resin layer and the third resin layer was over 0.1. The circular pattern of light was recognized on the solar cell modules in Examples 8 and 9. This seems to be because a difference in refractive indices between the first resin layer and the different resin layer was over 0.1.

The circular pattern of light was not recognized on the solar cell module in Example 10 although the difference in refractive indices between the first resin layer and the third resin layer was over 0.1. This seems to be because the substrate is formed of glass and not deformed during lamination forming like a resin substrate, and thus the deformation of the first resin layer and the third resin layer was prevented. As formed of glass, the solar cell module in Example 10 is heavy.

The circular pattern of light was not recognized on the external appearance of the solar cell module in Example 11. This seems to be because the first resin layer is in direct contact with the photoelectric converters, and thus refraction of light at the interface therebetween was not caused. The solar cell module is however preferably provided with the third resin layer in view of the impact resistance.

(Fourth resin layer 60)

The fourth resin layer 60 also protects the photoelectric converters 10 as a sealant as in the case of the first resin layer 30 and the second resin layer 40. The shape of the fourth resin layer 60 is not limited and may be a circle, an ellipse, or a polygon including a rectangle according to its use, as in the case of the second resin layer 40.

A material used to form the fourth resin layer 60 is not limited and may be at least one selected from a group consisting of thermoplastic resin, such as an ethylene vinyl acetate copolymer (EVA), polyvinyl butyral (PVB), polyethylene terephthalate (PET), polyolefin (PO) and polyimide (PI), and thermosetting resin, such as epoxy, urethane and polyimide. Modified resin may be used for these types of resin, and a combination thereof may be used. In particular, the fourth resin layer 60 preferably includes an ethylene vinyl acetate copolymer (EVA). In that case, the second resin layer 40 preferably includes polyolefin (PO).

As shown in FIG. 13, the solar cell module 100 may further include the fourth resin layer 60 provided under the second resin layer 40. The photoelectric converters 10 may be provided under the second resin layer 40 and over the fourth resin layer 60. Moreover, the tensile modulus of elasticity of the second resin layer 40 may be lower than a tensile modulus of elasticity of the fourth resin layer 60. Provision of the fourth resin layer 60 having such properties can improve the thermal shock resistance of the solar cell module 100 and prevent the cut of the connecting members 14 due to changes in temperature.

That is, although lighter than the glass substrate, the resin substrate has a coefficient of linear expansion higher than that of the glass substrate and is thus subject to big influence of thermal stress due to thermal contraction. When the resin substrate thermally contracts due to changes in temperature, the sealant thermally contracts, accordingly. As described above, the tensile modulus of elasticity of the first resin layer 30 is lower than the tensile modulus of elasticity of each of the resin substrate 20 and the second resin layer 40, and thus the first resin layer 30 can relieve the stress due to the thermal contraction of the resin substrate 20. In addition, when the tensile modulus of elasticity of the second resin layer 40 is lower than that of the fourth resin layer 60, the second resin layer 40 can relieve the thermal stress of the resin substrate 20 that is not relieved by the first resin layer 30. Accordingly, the cut of the connecting members 14 due to the thermal contraction of the resin substrate 20 can be further improved, and the thermal shock resistance of the solar cell module 100 can be enhanced.

In the embodiment as shown in FIG. 13, the second resin layer 40 is provided over the photoelectric converters 10, and the first resin layer 30 is provided over the second resin layer 40. The tensile modulus of elasticity of the first resin layer 30 is lower than that of the second resin layer 40. A difference in refractive indices between the first resin layer 30 and the second resin layer 40 is thus preferably 0.1 or less. As in the result shown by Examples 5 to 11, setting the difference in refractive indices in such a range can improve the external appearance of the solar cell module 100. Specifically, in the top view of the solar cell module 100, the circular pattern of light is hard to observe visually. The difference in refractive indices between the first resin layer 30 and the second resin layer 40 is more preferably 0.05 or less.

The fourth resin layer 60 may be arranged to cover the first resin layer 30 and the second resin layer 40 from outside to be glued to the resin substrate 20, as in the case of the second resin layer 40. This arrangement of the fourth resin layer 60 glued to the resin substrate 20 in addition to the second resin layer 40 is preferable because the holding effect and the barrier effect can be further improved as in the second resin layer.

(Back substrate 70)

The back substrate 70 can protect a surface of the solar cell module 100 on a side opposite to the light receiving surface side of the solar cell module 100, as a back sheet. The back substrate 70 may be provided under the second resin layer 40. The back substrate 70 may be specifically arranged on a side of the second resin layer 40, the side positioned ahead in the negative direction of the z axis. As described above, when the third resin layer 50 or the fourth resin layer 60 is provided, the back substrate 70 may be provided under the third resin layer 50 or the fourth resin layer 60.

A material used to form the back substrate 70 is not limited and may be at least one selected from a group consisting of glass, fiber-reinforced plastic (FRP), polyimide (PI), cyclic polyolefin, polycarbonate (PC), polymethyl methacrylate (PMMA), polyether ether ketone (PEEK), polystyrene (PS), polyethylene terephthalate (PET), and polyethylene naphthalate (PEN). Examples of fiber-reinforced plastic (FRP) include glass fiber-reinforced plastic (GFRP), carbon fiber-reinforced plastic (CFRP), and aramid fiber-reinforced plastic (AFRP). Examples of glass fiber-reinforced plastic (GFRP) include glass epoxy. The material to form the back substrate 70 preferably includes at least one selected from a group consisting of fiber-reinforced plastic (FRP), polymethyl methacrylate (PMMA), and polyether ether ketone (PEEK), because these materials are hard to be bent by an impact and the like and light in weight.

The back substrate 70 may be used as the light receiving surface according to its use. When the back substrate 70 is used as the light receiving surface, the solar cell module 100 according to the present embodiment has high-impact resistance as follows. That is, when the back substrate 70 is used as the light receiving surface, and an object such as hail hits the back substrate 70, since the tensile modulus of elasticity of the first resin layer 30 is lower than that of each of the resin substrate 20 and the second resin layer 40, the first resin layer 30 can serves as cushioning and disperse impact energy applied on the back substrate 70. Accordingly, the damage of the photoelectric converters 10 and the cutting of the connecting members 14 can be prevented.

The thickness of the back substrate 70 is preferably, but not limited to, 0.1 mm or greater and 10 mm or less, more preferably 0.2 mm or greater and 5.0 mm or less. The back substrate 70 having the thickness in such a range can prevent bending thereof and further can reduce the weight of the solar cell module 100.

A tensile modulus of elasticity of the back substrate 70 is preferably, but not limited to, 1.0 GPa or greater and 10.0 GPa or less, more preferably 2.3 GPa or greater and 2.5 GPa or less. Moreover, the tensile modulus of elasticity of the back substrate 70 is preferably higher than that of the first resin layer 30. That is, the tensile modulus of elasticity of the first resin layer 30 is preferably lower than that of each of the resin substrate 20, the second resin layer 40, and the back substrate 70.

A flexural rigidity of the back substrate 70 is preferably higher than that of the resin substrate 20. Specifically, the flexural rigidity of the back substrate 70 per width of 1 m is preferably higher than that of the resin substrate 20. The impact resistance of the solar cell module 100 toward an impact such as hail can be improved, accordingly.

The flexural rigidity is represented by the following formula (3):

[Math 3]

$$\text{Flexural rigidity (N·m}^2) = \text{flexural modulus of elasticity (Pa)} \times \text{second moment}$$
$$\text{of area (m}^4) \qquad (3)$$

The flexural modulus of elasticity may be determined in accordance with JIS K7171:2016 (Plastics-Determination of flexural properties). The flexural modulus of elasticity is determined by compressing a specimen at a test temperature of 25°C and a test speed of 5 mm/min, for example.
[Math 4]

$$E_f = (\sigma_{f2} - \sigma_{f1}) / (\varepsilon_{f2} - \varepsilon_{f1}) \qquad (4)$$

where, $E_f$ is flexural modulus of elasticity (Pa), $\sigma_{f1}$ is flexural stress (Pa) determined with deflection $s_1$, $\sigma_{f2}$ is flexural stress (Pa) determined with deflection $s_2$, and $\varepsilon_{fi}$ is flexural strain ($\varepsilon_1 = 0.0005$ and $\varepsilon_2 = 0.0025$).
The deflection is calculated by the following formula:
[Math 5]

$$s_i = \varepsilon_{fi} L^2 / 6h \qquad (5)$$

where $s_1$ is deflection (mm), $\varepsilon_{fi}$ is flexural strain ($\varepsilon_1 = 0.0005$ and $\varepsilon_2 = 0.0025$), L is distance between fulcrums (mm), and h is average thickness of specimens (mm).
The second moment of area is represented by the following formula when the area is a rectangular parallelepiped:
[Math 6]

$$I = bh^s / 12 \qquad (6)$$

where I is second moment of area (m$^4$), b is a width of a section (m), and h is a height of the section (m).
The impact resistance when the flexural rigidity of the back substrate was lower than that of the resin substrate was evaluated in the following examples. The present embodiment is however not limited to these examples.

[Example 12]

A solar cell module was manufactured by stacking a resin substrate having a thickness of 1 mm, a third resin layer having a thickness of 0.6 mm, photoelectric converters, a second resin layer having a thickness of 0.6 mm, and a back substrate having a thickness of 1 mm in sequence from above and compressing and heating at 145 °C under reduced pressure. Polycarbonate (PC) was used for the resin substrate. Polyolefin (PO) was used for the third resin layer. Solar cells were used for the photoelectric converters. Polyolefin (PO) was used for the second resin layer. Polycarbonate (PC) (flexural modulus of elasticity of 2.3 GPa) was used for the back substrate.

[Example 13]

A solar cell module was manufactured in the same way as in Example 12 except for using glass epoxy (flexural modulus of elasticity of 20 GPa) for the back substrate.

[Example 14]

A solar cell module was manufactured in the same way as in Example 12 except for using glass epoxy (flexural modulus of elasticity of 20 GPa) for the back substrate and setting the thickness of the back substrate to 2 mm.

(Impact resistance)

A test for the impact resistance was performed under the following conditions in accordance with a hail test prescribed in Annex 7 of JIS C8917:1998 (Environmental and endurance test methods for crystalline solar PV modules).

That is, a steel ball having a mass of 227 g ($\pm$ 2 g) and a diameter of approximately 38 mm was dropped on the central point of the resin substrate of the solar cell module in each example from a height of 1 m and a height of 20 cm without applying force. Then, a solar cell module having no photoelectric converter damaged by the ball dropped from the height of 1 m was judged as "1 m or greater". A solar cell module having no photoelectric converter damaged by the ball dropped from the height of 20 cm but having a photoelectric converter damaged by the ball dropped from 1 m was judged as "20 cm or greater and less than 1 m". Moreover, a solar cell module having a photoelectric converter damaged by the ball dropped from the height of 20 cm was judged as "less than 20 cm". The flexural rigidity is shown in a ratio such that the flexural rigidity in Example 12 is set to "1".

[Table 3]

| | Resin Substrate | Back Substrate | | | Evaluation Result |
|---|---|---|---|---|---|
| | Material | Material | Thickness | Flexural Rigidity (ratio) | |
| Example 12 | Polycarbonate | Polycarbonate | 1 mm | 1 | 20 cm or greater and less than 1 m |
| Example 13 | Polycarbonate | Glass epoxy | 1 mm | 8.7 | 20 cm or greater and less than 1 m |
| Example 14 | Polycarbonate | Glass epoxy | 2 mm | 70 | 1 m or greater |

The impact resistance in each example was evaluated by the hail test. As shown in Table 3, the solar cell modules in examples 12 and 13 have no photoelectric converters damaged at the height of 20cm but have photoelectric converters damaged at the height of 1 m. Meanwhile, the solar cell module in example 14 has no photoelectric converters damaged at the height of 1 m.

The result of examples 12 to 14 show that the impact resistance is improved when the flexural rigidity of the back substrate 70 is higher than that of the resin substrate 20. The back substrate 70 having a higher flexural rigidity seems to reduce the deflection of the entire module and prevent the solar cell module from being damaged. In the present embodiment, the flexural rigidity of the back substrate 70 is thus preferably higher than that of the resin substrate 20. That is, the solar cell module 100 preferably further includes the back substrate 70 provided under the second resin layer 40 and having a flexural rigidity higher than that of the resin substrate 20. In this case, the solar cell module may or may not include the above described third resin layer 50. Also, the solar cell module 100 preferably further includes the back substrate 70 provided under the fourth resin layer 60 and having a flexural rigidity higher than that of the resin substrate 20.

Moreover, a coefficient of thermal expansion of the back substrate 70 is preferably, but not limited to, higher than that of the resin substrate 20. The thermal shock resistance of the solar cell module 100 can be improved, and the cut of the connecting members 14 due to changes in temperature can be prevented, accordingly.

The thermal shock resistance when the coefficient of linear expansion of the back substrate was lower than that of the resin substrate was evaluated in the following examples. The present embodiment is however not limited to these examples.

[Example 15]

A solar cell module was manufactured by stacking a resin substrate having a thickness of 1 mm, a first resin layer having a thickness of 1 mm, a third resin layer having a thickness of 0.6 mm, photoelectric converters, a second resin layer having a thickness of 0.6 mm and a back substrate having a thickness of 2 mm in sequence from above and compressed and heating at 145 °C under reduced pressure. Polycarbonate (PC) (coefficient of linear expansion of 70 $\times$ 10$^{-6}$ K$^{-1}$) was used for the resin substrate. Gel was used for the first resin layer. An ethylene vinyl acetate copolymer (EVA) was used for the third resin layer. Solar cells were used for the photoelectric converters. An ethylene vinyl acetate copolymer (EVA) was used for the second resin layer. Carbon fiber-reinforced plastic (CFRP) (coefficient of linear expansion of 2.5 $\times$ 10$^{-6}$ K$^{-1}$) was used for the back substrate.

[Example 16]

A solar cell module was manufactured in the same way as in Example 15 except for using glass (coefficient of linear expansion of 9 $\times$ 10$^{-6}$ K$^{-1}$) for the back substrate.

[Example 17]

A solar cell module was manufactured in the same way as in Example 15 except for using glass epoxy (coefficient of linear expansion of $20 \times 10^{-6}$ K$^{-1}$) for the back substrate.

[Example 18]

A solar cell module was manufactured in the same way as in Example 15 except for not providing the first resin layer.

[Example 19]

A solar cell module was manufactured in the same way as in Example 15 except for not providing the first resin layer and using glass (coefficient of linear expansion of $9 \times 10^{-6}$ K$^{-1}$) for the back substrate.

[Example 20]

A solar cell module was manufactured in the same way as in Example 15 except for not providing the first resin layer and using glass epoxy (coefficient of linear expansion of $20 \times 10^{-6}$ K$^{-1}$) for the back substrate.

[Example 21]

A solar cell module was manufactured in the same way as in Example 15 except for not providing the first resin layer and using polycarbonate (PC) (coefficient of linear expansion of $70 \times 10^{-6}$ K$^{-1}$) for the back substrate.

(Thermal shock resistance)

The test for the thermal shock resistance was performed under the following test conditions in accordance with the temperature cycle test of JIS C8990:2009 (IEC61215:2005) (Crystalline silicon terrestrial photovoltaic (PV) modules-Design qualification and type approval). That is, the solar cell module in each example was placed in a test chamber, and the temperature of the solar cell module was changed cyclically between -40 °C ($\pm$ 2 °C) and 85 °C ($\pm$ 2 °C). The connecting members to connect solar cells each other were visually observed after the temperature cycle test was performed for 25 cycles, 50 cycles, and 200 cycles. A solar cell module having no connecting member cut after 200 cycles was judged as "200 or more", a solar cell module having no connecting member cut after 50 cycles and having a connecting member cut after 200 cycles as "50 or more and less than 200", a solar cell module having no connecting member cut after 25 cycles and having a connecting member cut after 50 cycles as "25 or more and less than 50", and a solar cell module having a connecting member cut after 25 cycles as "less than 25". Speed of change in temperature between the lower limit and the upper limit was set to about 1.4 °C / hour, a period of time to keep the lower limit temperature was set to 60 minutes, a period of time to keep the upper limit temperature was set to 1 hour and 20 minutes, and a period of time for one cycle was set to 5 hours and 20 minutes. The temperature cycle test was performed at least three times.

[Table 4]

| | Resin | Substrate | First Resin Layer | Back Substrate | | Evaluation Result |
|---|---|---|---|---|---|---|
| | Material | Coefficient of Linear Expansion ($\times 10^{-6}$ K$^{-1}$) | Material | Material | Coefficient of Linear Expansion ($\times 10^{-6}$ K$^{-1}$) | |
| Example 15 | PC | 70 | Gel | CFRP | 2.5 | 200 or more |
| Example 16 | PC | 70 | Gel | Glass | 9 | 50 or more and less than 200 |

(continued)

| | Resin | Substrate | First Resin Layer | Back Substrate | | Evaluation Result |
| --- | --- | --- | --- | --- | --- | --- |
| | Material | Coefficient of Linear Expansion ($\times 10^{-6}$ K$^{-1}$) | Material | Material | Coefficient of Linear Expansion ($\times 10^{-6}$ K$^{-1}$) | |
| Example 17 | PC | 70 | Gel | Glass epoxy | 20 | 25 or more and less than 50 |
| Example 18 | PC | 70 | - | CFRP | 2.5 | 50 or more and less than 200 |
| Example 19 | PC | 70 | - | Glass | 9 | 25 or more and less than 50 |
| Example 20 | PC | 70 | - | Glass epoxy | 20 | Less than 25 |
| Example 21 | PC | 70 | - | PC | 70 | Less than 25 |

The thermal shock resistance in each example was evaluated through the temperature cycle test. As show in Table 4, the solar cell module in Example 15 has no connecting member cut after 200 cycles. Meanwhile, the solar cell modules in Examples 16 and 18 have no connecting member cut after 50 cycles but have connecting members cut after 200 cycles. The solar cell modules in Examples 17 and 19 have no connecting member cut after 25 cycles but have connecting members cut after 50 cycles. The solar cell modules in Examples 20 and 21 have connecting members cut after 25 cycles. The result shows that the thermal shock resistance of the solar cell module 100 can be improved when the back substrate 70 has the coefficient of linear expansion lower than that of the resin substrate 20. Moreover, comparison of Examples 15 to 17 to Examples 18 to 21 shows that the thermal shock resistance can be also improved by using the gel having a comparative low tensile modulus of elasticity for the first resin layer.

The result of examples 15 to 21 show that the thermal shock resistance is improved when the coefficient of thermal expansion of the back substrate 70 is lower than that of the resin substrate 20. The back substrate 70 having a low coefficient of thermal expansion seems to prevent thermal contraction of the resin layer around the photoelectric converters and prevent the cut of the connecting members. Accordingly, the coefficient of thermal expansion of the back substrate 70 is preferably lower than that of the resin substrate 20 in the present embodiment. That is, the solar cell module 100 preferably further includes the back substrate 70 provided under the second resin layer 40 and having a coefficient of thermal expansion lower than that of the resin substrate 20. In that case, the solar cell module may or may not include the above described third resin layer 50. Also, the solar cell module 100 preferably further includes the back substrate 70 provided under the fourth resin layer 60 and having a coefficient of thermal expansion lower than that of the resin substrate 20.

(Low-heat expansion layer 80)

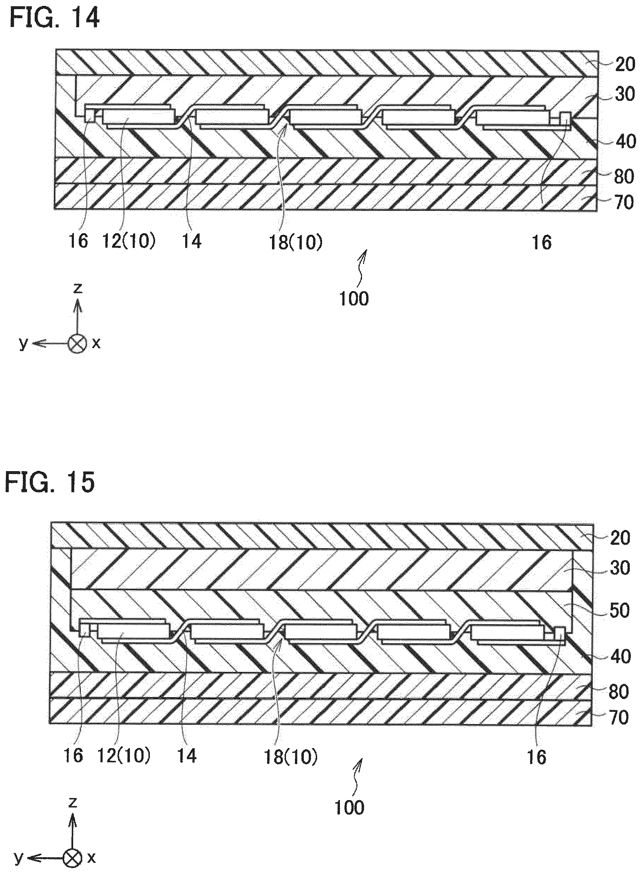

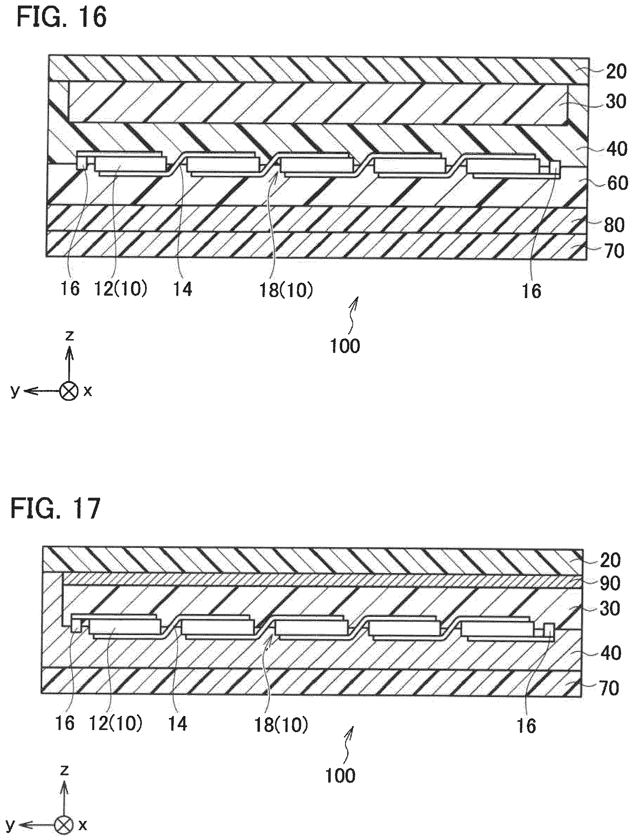

Examples 15 to 21 show that the thermal shock resistance of the solar cell module 100 is improved when the back substrate 70 has a coefficient of linear expansion lower than that of the resin substrate 20. Such an effect can be also obtained by providing a low-heat expansion layer 80 between the photoelectric converters 10 and the back substrate 70. The low-heat expansion layer 80 is thus preferably provided between the photoelectric converters 10 and the back substrate 70. Specifically, as show in FIG. 14, the solar cell module 100 preferably further includes the low-heat expansion layer 80 provided under the second resin layer 40 and having a coefficient of thermal expansion lower than that of the resin substrate 20. In this case, the solar cell module 100 may include the above described third resin layer 50 as in FIG. 15 or may not include the third resin layer 50. Also, as shown in FIG. 16, the solar cell module 100 preferably further includes the low-heat expansion layer 80 provided under the fourth rein layer 60 and having a coefficient of thermal expansion lower than that of the resin substrate 20.

The shape of the low-heat expansion layer 80 is not limited and may be a circle, an ellipse, or a polygon including a rectangle according to its use. The size of the low-heat expansion layer 80 is not limited and may be arranged along the connecting members 14. Such an arrangement can reduce the price of the solar cell module 100 even if the low-heat expansion layer 80, which is comparatively expensive, is used and improve the thermal shock resistance. Examples of the arrangement of the low-heat expansion layer 80 along the connecting members 14 include the low-heat expansion layer 80 provided below the photoelectric converters 10 in the vertical direction in contact with the photoelectric converters 10, and the low-heat expansion layer 80 provided below the photoelectric converters 10 in the vertical direction over a different layer. Here, below in the vertical direction is below in the stacking direction of the solar cell module 100 (z-axis direction). Moreover, in view of improving the thermal shock resistance, the low-heat expansion layer 80 is preferably arranged to cover the entire undersurface of the resin layer provided between the photoelectric converters 10 and the back substrate 70. Specifically, the low-heat expansion layer 80 is preferably provided under the second resin layer 40 in contact with the second resin layer 40 to cover the entire undersurface of the second resin layer 40. In this case, the solar cell module may or may not include the above described third resin layer 50. Also, the low-heat expansion layer 80 is preferably provided under the fourth resin layer 60 in contact with the fourth resin layer 60 to cover the entire undersurface of the fourth resin layer 60.

A material to form the low-heat expansion layer 80 is not limited and may be glass, paper, glass fiber, or ceramic sheet, for example. The material to form the low-heat expansion layer 80 preferably has a coefficient of thermal expansion equal to or lower than that of glass. Specifically, the coefficient of linear expansion is preferably greater than 0 and 10 $\times$ 10$^{-6}$ K$^{-1}$ or less.

(Lubrication layer 90)

As shown in FIG. 17, the solar cell module 100 preferably further includes a lubrication layer 90 provided between the resin substrate 20 and the first resin layer 30 and having a coefficient of static friction of 0.0001 to 0.1 between the resin substrate 20 and the first resin layer 30. The solar cell module 100 further including the lubrication layer 90 having such properties can prevent the thermal contraction of the resin substrate 20 from directly reaching the first resin layer 30 by the lubrication effect of the lubrication layer 90. Accordingly, the cut of the connecting members 14 due to the thermal contraction of the resin substrate 20 can be further prevented, and the thermal shock resistance of the solar cell module 100 can be improved. Setting the coefficient of static friction between the resin substrate 20 and the first resin layer 30 to 0.0001 or greater is preferable because the thermal shock resistance of the solar cell module 100 can be improved. Setting the coefficient of static friction between the resin substrate 20 and the first resin layer 30 to 0.1 or less is preferable because adhesion between the resin substrate 20 and the first resin layer 30 can be improved. The arrangement of the second resin layer 40 shown in FIGS. 7 to 9 to surround the entire periphery of the first resin layer 30 in a plane view to be glued to the resin substrate 20 is preferable because leakage of the lubrication layer 90 can be prevented.

The coefficient of static friction between the resin substrate 20 and the first resin layer 30 is determined, for example, in accordance with a method described in JIS K7125:1999 (Plastics-Film and sheeting-Determination of the coefficients of friction).

The thickness of the lubrication layer 90 is preferably 0.01 μm to 100 μm. In view of the adhesion, the thickness of the lubrication layer 90 is preferably 0.01 μm to 75 μm, more preferably 0.01 μm to 50 μm.

A material to form the lubrication layer 90 preferably includes grease. Grease starts flowing when an external force greater than or equal to a yield value is applied, while large fluid resistance works when the external force is less than the yield value. Accordingly, the thermal shock resistance of the solar cell module 100 can be improved, and handling of the solar cell module 100 can be facilitated.

Grease is a lubricant in a semisolid state or a solid state, which is made by mixing a base oil with a thickener. In addition to the base oil and the thickener, a dispersant, an antioxidant, or the like may be added to grease as necessary.

Examples of the base oil include a purified mineral oil, a synthetic lubricating oil, and a mixed oil of theses oils. The purified mineral oil may be obtained by distilling a crude oil, for example. Examples of the synthetic lubricating oil include polyolefin, polyester, polyalkylene glycol, alkylbenzenes, and alkyl naphthalene.

Examples of the thickener include a soap-based thickener and a non-soap-based thickener. Examples of a soap-based thickener include a metal soap-based thickener, such as a calcium soap, an aluminum soap and a lithium soap, and a complex soap-based thickener, such as a calcium complex, an aluminum complex and a lithium complex. Examples of non-soap-based thickener include a urea-based thickener, such as diurea, triurea and polyurea, an organic-based thickener, such as polytetrafluoroethylene (PTFE) and sodium terephthalate, and an inorganic-based thickener, such as bentonite and silica gel.

Examples of grease include silicon-based grease, silicone-based grease, fluoroether-based grease, and fluoroalkyl-based grease. Among these types of grease, in view of the thermal resistance, grease preferably includes at least one of silicone-based grease and fluoroalkyl-based grease (Teflon (registered trademark) -based grease).

Grease is preferably in a semisolid state within a range between -40 °C and 150 °C. Setting the grease in a semisolid state within a range between -40 °C and 150 °C can reduce the leakage and facilitate handling of the solar cell module 100.

A dropping point of grease is preferably 150 °C or lower. The grease having such a range of the dropping point can keep lubrication between the resin substrate 20 and the first resin layer 30 for a long time although the temperature of the solar cell module 100 goes high. The dropping point is determined, for example, in accordance with a dropping point test method prescribed in JIS K2200:2013 (Lubricating Grease).

A melting point of grease is preferably -40 °C or higher. The grease having such a range of the melting point can keep lubrication between the resin substrate 20 and the first resin layer 30 and improve the thermal shock resistance of the solar cell module 100 also in cold district.

The coefficient of static friction between the resin substrate 20 and the first resin layer 30 at -40 °C is preferably 0.0001 to 0.1. Setting the coefficient of static friction between the resin substrate 20 and the first resin layer 30 at -40 °C to such a range can improve the thermal shock resistance of the solar cell module 100 also in cold district.

(Oxygen barrier layer 95)

The solar cell module 100 according to the present embodiment preferably further includes oxygen barrier layers 95 having an oxygen transmission rate of 200 $cm^3$ / $m^2$ ▪ 24h ▪ atm or lower. The oxygen barrier layers 95 are respectively provided over the first resin layer 30 and under the second resin layer 40. Specifically, when the photoelectric converters 10 are provided over the second resin layer 40, the solar cell module 100 preferably further includes the oxygen barrier layers 95 having a predetermined oxygen transmission rate and respectively provided over the first resin layer 30 and under the second resin layer 40. Provision of the oxygen barrier layers 95 having such properties can reduce the amount of oxygen entering the solar cell module 100 and the number of radicals, which are derived from oxygen, generated within the first resin layer 30 and the second resin layer 40. Accordingly, decomposition of the resin due to the radicals and a change of color of the resin can be prevented.

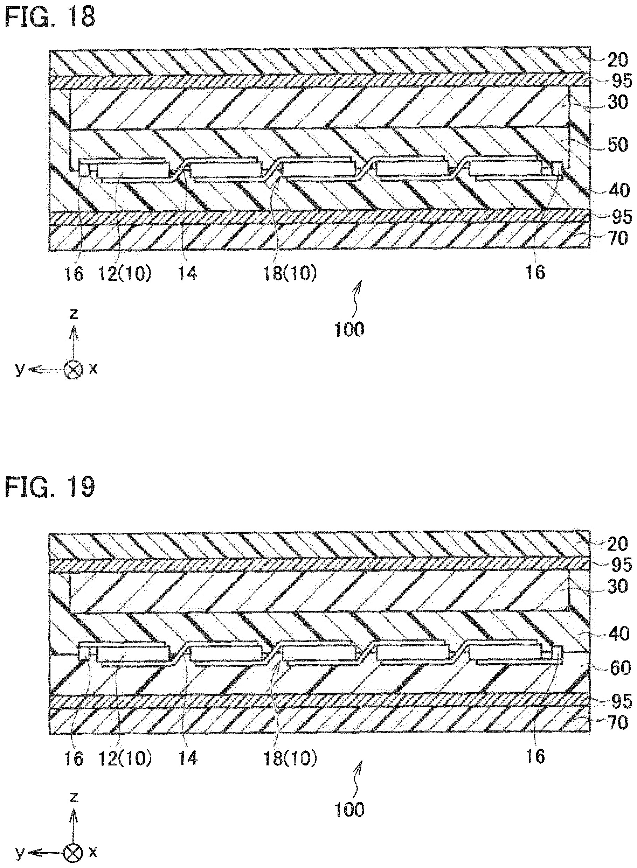

In the present embodiment, the oxygen barrier layer 95 may be provided above the first resin layer 30. The oxygen barrier layer 95 may be specifically provided between the first resin layer 30 and the resin substrate 20. The oxygen barrier layer 95 here may be in direct contact with the first resin layer 30 as in the embodiment in FIG. 18 or may not be in direct contact with the first resin layer 30. For example, the oxygen barrier layer 95 may be provided over the resin substrate 20. In addition to the oxygen barrier layer 95, or instead of the oxygen barrier layer 95, an oxygen transmission rate of the resin substrate 20 may be set to 200 $cm^3$/$m^2$ ▪ 24h ▪ atm or lower.

Moreover, in the present embodiment, the oxygen barrier layer 95 may be provided below the second resin layer 40. For example, as in the embodiment in FIG. 18, the oxygen barrier layer 95 may be specifically provided between the second resin layer 40 and the back substrate 70. The oxygen barrier layer 95 here may be in direct contact with the second resin layer 40 as in the embodiment in FIG. 18 or may not be in direct contact with the second resin layer 40. For example, the oxygen barrier layer 95 may be provided under the back substrate 70. In addition to the oxygen barrier layer 95 or instead of the oxygen barrier layer 95, an oxygen transmission rate of the back substrate 70 may be set to 200 $cm^3$/$m^2$ ▪ 24h ▪ atm or lower.

The solar cell module 100 according to the present embodiment preferably further includes the oxygen barrier layers having an oxygen transmission rate of 200 $cm^3$/$m^2$ ▪ 24h ▪ atm or lower and respectively provided over the first resin layer 30 and under the fourth resin layer 60. Specifically, when the photoelectric converters 10 are provided under the second resin layer 40 and over the fourth resin layer 60, the solar cell module 100 preferably further includes the oxygen barrier layers having a predetermined oxygen transmission rate and respectively provided over the first resin layer 30 and under the fourth resin layer 60. Provision of the oxygen barrier layers 95 having such properties can reduce the amount of oxygen entering the solar cell module 100 and the number of radicals, which are derived from oxygen, generated within the first resin layer 30, the second resin layer 40 and the fourth resin layer 60. Accordingly, decomposition of the resin due to the radicals and a change of color of the resin can be prevented.

In the present embodiment, the oxygen barrier layer 95 may be provided below the fourth resin layer 60. As in the embodiment in FIG. 19, the oxygen barrier layer 95 may be specifically provided between the fourth resin layer 60 and the back substrate 70. The oxygen barrier layer 95 here may be in direct contact with the fourth resin layer 60 as in the embodiment in FIG. 19 or may not be in direct contact with the fourth resin layer 60. For example, the oxygen barrier layer 95 may be provided under the back substrate 70. In addition to the oxygen barrier layer 95 or instead of the oxygen barrier layer 95, an oxygen transmission rate of the back substrate 70 may be set to 200 $cm^3$/$m^2$ ▪ 24h ▪ atm or lower.

Positions of the oxygen barrier layers 95 are not limited to the above described positions. Specifically, the oxygen barrier layer 95 may be provided over a lower surface of the first resin layer 30, on a lower surface of the back substrate 70, within the first resin layer 30, within the second resin layer 40, within the third resin layer 50, within the fourth resin layer 60, and the like. Moreover, the oxygen barrier layers 95 may be arranged on a side surface of the solar cell module 100. In this case, the amount of oxygen entering the solar cell module 100 from the side surface can be reduced. Moreover, each of the first resin layer 30, the second resin layer 40, the third resin layer 50, and the fourth resin layer 60 may be surrounded by the oxygen barrier layer 95.

The oxygen transmission rate of the oxygen barrier layer 95 is preferably 200 cm$^3$/m$^2$ ▪ 24h ▪ atm or lower, more preferably 0.001 to 200 cm$^3$/m$^2$ ▪ 24h ▪ atm. The oxygen transmission rate in such a range can prevent a change of color of the resin within the solar cell module 100. The oxygen transmission rate may be determined in accordance with JIS K7126-2 (Plastics-Film and sheeting-Determination of gas-transmission rate. Part 2: Equal-pressure method.). The oxygen transmission rate may be determined at a measurement temperature of 23 °C and a measurement humidity of 90 %.

Examples of a material used to form the oxygen barrier layer 95 include polyvinyl chloride (PVC), polyethylene terephthalate (PET), cast nylon (CNY), biaxially oriented nylon (ONY), polyvinylidene chloride (PVDC) coated biaxially oriented polypropylene (OPP), polyvinylidene chloride (PVDC) coated biaxially oriented nylon (ONY), poly (m-xylylene adipamide) (nylon-MXD6), an ethylene-vinylalcohol copolymer (EVOH), a vinylidene chloride-methylacrylate copolymer, alumina coated PET, silica coated PET, and nanocomposite-type coated PET.

As described above, the solar cell module 100 according to the present embodiment includes the resin substrate 20, the first resin layer 30, the photoelectric converters 10, and the second resin layer 40. The first resin layer 30 is provided under the resin substrate 20. The photoelectric converters 10 are provided under the first resin layer 30. The second resin layer 40 is provided under the first resin layer 30 to penetrate the first resin layer 30 or cover the first resin layer 30 from outside to be glued to the resin substrate 20. Adjacent photoelectric converters 10 are electrically connected to each other by the connecting members 14. The tensile modulus of elasticity of the first resin layer 30 is lower than that of each of the resin substrate 20 and the second resin layer 40. Accordingly, the impact resistance of the solar cell module 100 can be improved, and the effect of firmly holding the photoelectric converters 10 with respect to the resin substrate 20 can be enhanced.

(Manufacturing method of solar cell module 100)

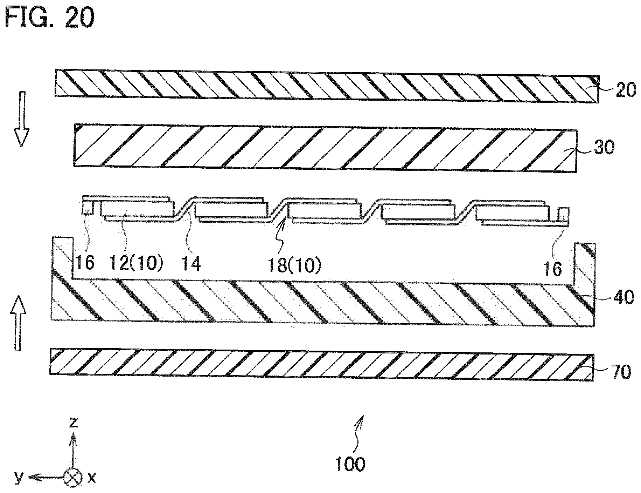

The solar cell module 100 according to the present embodiment may be manufactured in a known method. For example, as shown in FIG. 20, the solar cell module may be formed by stacking the resin substrate 20, the first resin layer 30, the photoelectric converters 10, the second resin layer 40, and the back substrate 70 in sequence and compressing while heated. Details of steps are not limited, and each layer may be formed in divided steps by compression forming according to its use. For example, when the photoelectric converters 10 each have a front portion, a back portion, and side portions, the side portions and the back portion of each of the photoelectric converters 10 may be glued to the second resin layer 40 and then glued to other members such as the first resin layer 30. Accordingly, the effect of firmly holding the photoelectric converters 10 with respect to the second resin layer 40 can be further improved.

Heating conditions are not limited, and the stacked body may be heated to approximately 150 °C in a vacuum, for example. Heating in a vacuum is preferable because removing of bubbles is further improved. After heating in a vacuum, each layer may be heated by a heater or the like while compressed under atmospheric pressure so that resin components are cross-linked. Moreover, a frame may be attached to the stacked body obtained by heating.

The manufacturing method of the solar cell module 100 according to the present embodiment is not limited as described above and preferably includes a step of stacking the first resin layer 30 having an area smaller than that of the second resin layer 40 in a plane view, over or under the second resin layer 40 and gluing the resin substrate 20 and the second resin layer 40 together. That is, the manufacturing method of the solar cell module 100 is a manufacturing method of the solar cell module 100 including the resin substrate 20, the first resin layer 30, the photoelectric converters 10, and the second resin layer 40. The first resin layer 30 is provided under the resin substrate 20. The photoelectric converters 10 are provided under the first resin layer 30. The second resin layer 40 is provided under the first resin layer 30 to surround the entire periphery of the first resin layer 30 in a plane view to be glued to the resin substrate 20. Adjacent photoelectric converters 10 may be electrically connected to each other by the connecting members 14. The tensile modulus of elasticity of the first resin layer 30 is lower than that of each of the resin substrate 20 and the second resin layer 40. The manufacturing method of the solar cell module 100 includes a step of stacking the first resin layer 30 having an area smaller than that of the second resin layer 40 in a plane view on the second resin layer 40 and gluing the resin substrate 20 and the second resin layer 40 together.

Having such a step can prevent the first resin layer 30 from going over the second resin layer 40 because the second resin layer 40 is to be pressurized such that the periphery of the second resin layer 40 is covered by the first resin layer 30 as shown in FIG. 20. At this time, the volume of the first resin layer 30 to be stacked is preferably equal to or greater than the volume of a concave portion of the second resin layer 40, which is formed to surround the first resin layer 30. Accordingly, the first resin layer 30 going over the second resin layer 40 can be prevented, and a space formed between the first resin layer 30 and the second resin layer 40 can be prevented.

The present embodiment preferably includes a step of stacking the first resin layer 30 within the concave portion of the second resin layer 40. Having such a step allows a suitable amount of the first resin layer 30 to be arranged in the concave portion of the second resin layer 40 when the first resin layer 30 particularly includes a material having a low viscosity such as a liquid or a half liquid. Accordingly, a material having a lower tensile modulus of elasticity can be used for the first resin layer 30. Consequently, the impact resistance of the solar cell module 100 can be further improved.

The entire content of Japanese Patent Application No. 2016-108199 (filing date: May 31, 2016) and Japanese Patent Application No. 2016-250884 (filing date: December 26, 2016) are herein incorporated by reference.

The present embodiment is described above with examples. The present embodiment is however not limited to these examples, and various modifications can be made within the scope of the present embodiment.

INDUSTRIAL APPLICABILITY

The present invention provides a solar cell module having a high-impact resistance and an enhanced effect of holding the photoelectric converters firmly and a manufacturing method thereof.

REFERENCE SIGNS LIST

| 10 | PHOTOELECTRIC CONVERTER |
| 14 | CONNECTING MEMBER |
| 20 | RESIN SUBSTRATE |
| 30 | FIRST RESIN LAYER |
| 35 | SLIT |
| 40 | SECOND RESIN LAYER |
| 50 | THIRD RESIN LAYER |
| 60 | FOURTH RESIN LAYER |
| 70 | BACK SUBSTRATE |
| 80 | LOW-HEAT EXPANSION LAYER |
| 90 | LUBRICATION LAYER |
| 95 | OXYGEN BARRIER LAYER |
| 100 | SOLAR CELL MODULE |

**Claims**

1. A solar cell module comprising:

   a resin substrate;
   a first resin layer provided under the resin substrate;
   photoelectric converters provided under the first resin layer; and
   a second resin layer provided under the first resin layer to penetrate the first resin layer or cover the first resin layer from outside to be glued to the resin substrate;
   wherein adjacent photoelectric converters of the photoelectric converters are electrically connected to each other by a connecting member, and
   wherein a tensile modulus of elasticity of the first resin layer is lower than a tensile modulus of elasticity of the resin substrate and a tensile modulus of elasticity of the second resin layer.

2. The solar cell module according to claim 1, wherein
   the second resin layer is arranged to cover an entire edge of the first resin layer from outside to be glued to the resin substrate, the entire edge in at least one direction in a plane view.

3. The solar cell module according to claim 1 or 2, wherein
   the second resin layer is arranged to sandwich the first resin layer therebetween at both ends of the first resin layer to be glued to the resin substrate, the both ends extending along a direction perpendicular to a connecting direction of the photoelectric converters connected by the connecting member.

4. The solar cell module according to claim 1 or 2, wherein
   the second resin layer is arranged to sandwich the first resin layer therebetween at both ends of the first resin layer to be glued to the resin substrate, the both ends extending along a connecting direction of the photoelectric converters connected by the connecting member.

**5.** The solar cell module according to any one of claims 1 to 4, wherein
the second resin layer is arranged to surround the entire periphery of the first resin layer in a plane view to be glued to the resin substrate.

**6.** The solar cell module according to any one of claims 1 to 5, wherein
the second resin layer is arranged to penetrate the first resin layer and surround the entire periphery of the first resin layer in a plane view to be glued to the resin substrate.

**7.** The solar cell module according to any one of claims 1 to 6, wherein
a difference in refractive indices between the first resin layer and a resin layer that is adjacent to the first resin layer and provided over the photoelectric converters is 0.1 or less.

**8.** The solar cell module according to any one of claims 1 to 7, wherein

the photoelectric converters are provided over the second resin layer, and
the second resin layer is arranged to surround each entire periphery of two or more of the photoelectric converters in a plane view to be glued to the resin substrate.

**9.** The solar cell module according to claim 8, further comprising:
oxygen barrier layers having an oxygen transmission rate of 200 cm$^3$/m$^2$ ▪ 24h ▪ atm or lower and respectively provided over the first resin layer and under the second resin layer.

**10.** The solar cell module according to any one of claims 1 to 9, further comprising:

a third resin layer provided under the first resin layer and over the second resin layer,
wherein the photoelectric converters are provided under the third resin layer and over the second resin layer, and
a tensile modulus of elasticity of the third resin layer is lower than the tensile modulus of elasticity of the second resin layer.

**11.** The solar cell module according to claim 10, further comprising:
a low-heat expansion layer provided under the second resin layer and having a coefficient of thermal expansion lower than that of the resin substrate.

**12.** The solar cell module according to claim 10 or 11, further comprising:
a back substrate provided under the second resin layer and having a flexural rigidity higher than that of the resin substrate.

**13.** The solar cell module according to any one of claims 1 to 7, further comprising:

a fourth resin layer provided under the second resin layer,
wherein the photoelectric converters are provided under the second resin layer and over the fourth resin layer, and
the tensile modulus of elasticity of the second resin layer is lower than a tensile modulus of elasticity of the fourth resin layer.

**14.** The solar cell module according to claim 13, further comprising:
oxygen barrier layers having an oxygen transmission rate of 200 cm$^3$/m$^2$ ▪ 24h ▪ atm or lower and respectively provided over the first resin layer and under the fourth resin layer.

**15.** The solar cell module according to claim 13 or 14, further comprising:
a low-heat expansion layer provided under the fourth resin layer and having a coefficient of thermal expansion lower than that of the resin substrate.

**16.** The solar cell module according to any one of claims 13 to 15, further comprising:
a back substrate provided under the fourth resin layer and having a flexural rigidity higher than that of the resin substrate.

**17.** The solar cell module according to any one of claims 1 to 9, further comprising:
a back substrate provided under the second resin layer and having a flexural rigidity higher than that of the resin substrate.

18. The solar cell module according to any one of claims 1 to 17, wherein

the resin substrate includes polycarbonate, and
the first resin layer includes at least one selected from a group consisting of silicone gel, acrylic gel and urethane gel.

19. The solar cell module according to any one of claims 1 to 18, wherein
a water vapor transmission rate of the second resin layer is lower than that of the first resin layer.

20. The solar cell module according to any one of claims 1 to 19, wherein

the first resin layer includes gel, and
the first resin layer is provided with slits.

21. The solar cell module according to any one of claims 1 to 20, further comprising:
a lubrication layer provided between the resin substrate and the first resin layer and having a coefficient of static friction of 0.0001 to 0.1 between the resin substrate and the first resin layer.

22. The solar cell module according to any one of claims 1 to 21, wherein
the connecting member include aluminum.

23. A manufacturing method of a solar cell module, the solar cell module comprising:

a resin substrate;
a first resin layer provided under the resin substrate;
photoelectric converters provided under the first resin layer; and
a second resin layer provided under the first resin layer to surround the entire periphery of the first resin layer in a plane view to be glued to the resin substrate,
wherein adjacent photoelectric converters of the photoelectric converters are electrically connected to each other by a connecting member, and
a tensile modulus of elasticity of the first resin layer is lower than a tensile modulus of elasticity of the resin substrate and a tensile modulus of elasticity of the second resin layer,
the method comprising:
a step of stacking the first resin layer having an area smaller than that of the second resin layer in a plane view over or under the second resin layer and gluing the resin substrate and the second resin layer together.

FIG. 1

FIG. 2

FIG. 3

FIG. 4

FIG. 5

## FIG. 6

FIG. 7

FIG. 8

FIG. 9

FIG. 10

FIG. 11

# FIG. 12

| EXAMPLE5 | EXAMPLE6 | EXAMPLE7 |
| --- | --- | --- |

# FIG. 13

FIG. 14

FIG. 15

FIG. 16

16  12(10)  14  18(10)  16

100

FIG. 17

16  12(10)  14  18(10)  16

100

FIG. 18

FIG. 19

FIG. 20

16  12(10)  14    18(10)                16

z
y ← ⊗ → x

100

## INTERNATIONAL SEARCH REPORT

| | International application No. |
|---|---|
| | PCT/JP2017/018166 |

**A. CLASSIFICATION OF SUBJECT MATTER**
*H01L31/048(2014.01)i*

According to International Patent Classification (IPC) or to both national classification and IPC

**B. FIELDS SEARCHED**

Minimum documentation searched (classification system followed by classification symbols)
H01L31/048

Documentation searched other than minimum documentation to the extent that such documents are included in the fields searched
Jitsuyo Shinan Koho          1922-1996   Jitsuyo Shinan Toroku Koho   1996-2017
Kokai Jitsuyo Shinan Koho   1971-2017   Toroku Jitsuyo Shinan Koho   1994-2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br><br>A | JP 2011-49485 A  (Kyocera Corp.),<br>10 March 2011 (10.03.2011),<br>entire text; fig. 1, 4<br>(Family: none) | 1-9,17-20,<br>22-23<br>10-16,21 |
| Y<br><br>A | JP 2011-176231 A  (Sanyo Electric Co., Ltd.),<br>08 September 2011 (08.09.2011),<br>paragraphs [0029] to [0070]; fig. 3<br>& WO 2011/105389 A1      & EP 2549549 A1<br>& US 2012/0312359 A1<br>paragraphs [0043] to [0085]; fig. 3 | 1-9,17-20,<br>22-23<br>10-16,21 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 03 July 2017 (03.07.17) | 25 July 2017 (25.07.17) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
|---|---|

Form PCT/ISA/210 (second sheet) (January 2015)

**INTERNATIONAL SEARCH REPORT**

| International application No. |
| --- |
| PCT/JP2017/018166 |

C (Continuation).  DOCUMENTS CONSIDERED TO BE RELEVANT

| Category* | Citation of document, with indication, where appropriate, of the relevant passages | Relevant to claim No. |
| --- | --- | --- |
| Y | JP 2008-235603 A  (Sanyo Electric Co., Ltd.),<br>02 October 2008 (02.10.2008), | 1-9,17-20,<br>22-23 |
| A | paragraphs [0005] to [0060]; fig. 2, 5<br>& US 2008/0230114 A1<br>paragraphs [0024] to [0074]; fig. 2, 5<br>& US 2014/0106497 A1    & EP 1973171 A2 | 10-16,21 |
| Y | JP 2014-222768 A  (Nitto Denko Corp.),<br>27 November 2014 (27.11.2014),<br>paragraphs [0074] to [0128]; fig. 2<br>(Family: none) | 7-9,17-20,22 |
| Y | JP 2011-86925 A  (Mitsubishi Chemical Corp.),<br>28 April 2011 (28.04.2011),<br>paragraphs [0140] to [0145]<br>& EP 2463929 A1<br>paragraphs [0442] to [0458]<br>& US 2012/0211082 A1    & WO 2011/016430 A1<br>& CN 102473843 A | 9,17-20,22 |
| Y | JP 2003-204074 A  (Sharp Corp.),<br>18 July 2003 (18.07.2003),<br>paragraphs [0011] to [0013], [0038] to [0054]<br>& US 2003/0098060 A1<br>paragraphs [0013] to [0015], [0045] to [0059] | 20,22 |
| A | WO 2012/017538 A1  (Mitsubishi Electric Corp.),<br>09 February 2012 (09.02.2012),<br>paragraphs [0027] to [0031]<br>& US 2013/0102104 A1<br>paragraphs [0031] to [0035]<br>& CN 103053029 A | 1-23 |

Form PCT/ISA/210 (continuation of second sheet) (January 2015)

**EP 3 467 880 A1**

### Patent documents cited in the description

- JP 2013145807 A
- JP 2016108199 A
- JP 2016250884 A